(19)

**Europäisches Patentamt**
**European Patent Office**
**Office européen des brevets**

(11) **EP 4 040 631 A1**

(12) **EUROPEAN PATENT APPLICATION**

(43) Date of publication:
**10.08.2022 Bulletin 2022/32**

(51) International Patent Classification (IPC):
***H02J 7/00*** *(2006.01)*

(21) Application number: **22155063.5**

(22) Date of filing: **03.02.2022**

(52) Cooperative Patent Classification (CPC):
**H02J 7/0025**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **05.02.2021 JP 2021017036**

(71) Applicant: **TOYOTA JIDOSHA KABUSHIKI KAISHA**
**Toyota-shi, Aichi-ken, 471-8571 (JP)**

(72) Inventors:
• **YANAGIZAWA, Naoki**
  **Nagakute-shi, 480-1192 (JP)**
• **GOH, Teckchiang**
  **Nagakute-shi, 480-1192 (JP)**

• **OOTSUKA, Kazuo**
  **Nagakute-shi, 480-1192 (JP)**
• **TSUKADA, Hiroshi**
  **Nagakute-shi, 480-1192 (JP)**
• **TOMURA, Shuji**
  **Nagakute-shi, 480-1192 (JP)**
• **IZUMI, Junta**
  **Toyota-shi, 471-8571 (JP)**
• **KIMURA, Kenji**
  **Toyota-shi, 471-8571 (JP)**
• **MATSUMOTO, Junichi**
  **Toyota-shi, 471-8571 (JP)**
• **HABU, Masakazu**
  **Toyota-shi, 471-8571 (JP)**

(74) Representative: **D Young & Co LLP**
**120 Holborn**
**London EC1N 2DY (GB)**

(54) **POWER SUPPLY SYSTEM**

(57) A power supply system (200) includes a power supply circuit (100) that includes a plurality of battery modules (102), each of which has a battery (10). The power supply circuit (100) is configured such that the batteries (10) in the battery modules (102) are connected to each other in series in response to a gate driving signal from a controller (104). An alternating current voltage having a different phase is output by temporally changing the number of the batteries (10) connected in series in each of a plurality of power supply circuits (100).

**FIG. 6**

EP 4 040 631 A1

**Description**

BACKGROUND OF THE INVENTION

1. Field of the Invention

The present invention relates to a power supply system in which battery modules are connected in series.

2. Description of Related Art

A power supply device is used in which a plurality of battery modules is connected in series to supply power to a load (power running). In a case where a battery included in the battery module is a secondary battery, the battery can be charged from a load side (regeneration). In such a power supply device, the power supply device including a switching circuit that connects or disconnects each battery module to or from the load based on a gate driving signal has been proposed (Japanese Unexamined Patent Application Publication No. 2018-074709).

A configuration in which a power storage device is connected to a load or a grid power supply via a DC/DC converter and an inverter is also disclosed (Japanese Unexamined Patent Application Publication No. 2019-216536 (JP 2019-216536 A)).

Further, a power compensator that executes power compensation in a three-phase power grid is disclosed. The power compensator has a configuration in which N cell power modules (N is an integer of 2 or higher) are installed for each phase of the power grid, and single-phase power sides of the single-phase inverters of N cell power modules installed for each phase of the power grid are connected in series and the power storage unit is connected to a direct current power side of the single-phase inverter. Each of the cell power modules includes a power storage unit that stores power to be compensated and a single-phase inverter that charges and discharges the power storage unit to convert between single-phase power and direct current power (Japanese Unexamined Patent Application Publication No. 2007-37290 (JP 2007-37290 A)).

Further, another disclosure is an n-stage single-phase output power conversion device which includes n single-phase output inverter bridges 1 to 4 capable of executing a three-level output and in which output terminals of the inverter bridges are connected in series. The power conversion device includes a voltage amplitude ratio distribution unit that sets an amplitude ratio of V1, V2, V3, and Vn of each output voltage of n inverter bridges to V1:V2:V3:Vn = 1:2:4:2 (n-1), a command voltage generation unit that generates a voltage closest to the output voltage command given to the power conversion device by combining the output voltages of the inverter bridges, and an output voltage adjusting unit that executes pulse-width modulation on the inverter bridge and adjusts the generated voltage such that an average value of the output voltages of the entire power conversion device is equal to the voltage command. Consequently, the power conversion device is capable of further reducing harmonics as compared with an existing power conversion device employing a multiple pulse width modulation (Japanese Unexamined Patent Application Publication No. 11-89242 (JP 11-89242 A)).

Further, a system is disclosed which includes a plurality of energy storage modules and in which the energy storage modules are connected in series in a plurality of energy supply branches (Japanese Unexamined Patent Application Publication (Translation of PCT Application) No. 2015-501127). The total output voltage of the energy supply branch can be adjusted stepwise by increasing or decreasing the number of energy storage modules for each energy supply branch.

SUMMARY OF THE INVENTION

However, the invention disclosed in JP 2019-216536 A has challenges in that the power conversion circuit is expensive because it is configured to be connected to the system by using two power conversion circuits, which are the DC/DC converter and the inverter. Since it is necessary to execute power conversion twice, there is also a challenge in that efficiency is decreased.

In the invention disclosed in JP 2007-37290 A, the single-phase inverter is used to enable an output of a negative output voltage. However, four switch elements are required and thus there is a challenge in that it is expensive. Since a switch of each cell power module executes series multiplex PWM control and it is necessary to give a separate gate signal to each cell power module, the number of output signals from a controller is increased as the number of cell power modules is increased. However, there is a challenge in that a controller cost is increased. Moreover, control when a capacity of a storage battery varies fails to be taught or suggested.

In the technology disclosed in JP 11-89242 A, to set the amplitude ratio of the amplitudes V1, V2, V3, and Vn of each output voltage of the inverter bridges to V1:V2:V3:Vn = 1:2:4:2 (n-1), it is necessary to set an input voltage to each single-phase output inverter bridge, that is, a battery voltage to the amplitude ratio. However, there is a challenge in that it cannot be implemented in a case where batteries have the same voltage.

A power supply system according to a first aspect of the present invention includes a power supply circuit that includes a plurality of battery modules, each of which has a battery. The power supply circuit is configured to transfer a gate driving signal from a controller between the battery modules such that batteries in the battery modules are connected to each other in series. An alternating current voltage having a different phase is output by temporally changing the number of batteries connected in series in each of a plurality of power supply circuits.

In the above aspect, the gate driving signal may be given from the controller to each of the power supply circuits.

In the above aspect, each of the battery modules may include a first switch element configured to be turned on or off in response to the gate driving signal to disconnect the battery from series connection, a second switch element configured to be turned on or off in response to the gate driving signal to connect the battery in series, and a gate driving signal processing circuit configured to delay the gate driving signal at regular time intervals and transmit the gate driving signal to the next-stage battery module connected in series.

In the above aspect, each of the battery modules may be a half-bridge module including the first switch element and the second switch element. An alternating current voltage without a voltage offset may be output as a difference between voltages output by the power supply circuits, by outputting an alternating current voltage having the same voltage offset in each of the power supply circuits.

In the above aspect, each of the battery modules may be a full-bridge module including the first switch element and the second switch element. An alternating current voltage without a voltage offset may be output in each of the power supply circuits.

In the above aspect, the power supply circuit may have a configuration in which the power supply circuit is divided into a plurality of sub-battery module groups where the battery modules are connected in series, and the positive electrode sides or the negative electrode sides of one of the sub-battery module groups and another sub-battery module group are connected to each other.

In the above aspect, the power supply circuits may be Y-connected to each other to generate a three-phase alternating current voltage in which voltages have different phases from each other by 120°.

In the above aspect, the power supply system may further include a transformer connected to a load side. A neutral point of the Y-connected power supply circuit and a neutral point of the transformer may be connected via a capacitor.

In the above aspect, two sets of the power supply circuits may be connected to generate a single-phase alternating current voltage in which voltages have different phases from each other by 180°.

In the above aspect, the power supply system may further include a battery level estimation unit configured to estimate the stored power amount of the power supply circuit. A power command value used for determining the output power of the power supply circuit may be set according to the stored power amount.

In the above aspect, the power supply system may further include current sensors configured to detect a phase current in a system of each phase of the alternating current voltage having phases that are different from each other, and voltage sensors configured to detect the phase voltage in the system. Each of the current sensors is directly or indirectly connected to the power supply circuit. The power supply circuit may be controlled according to the phase current and the phase voltage.

In the above aspect, a plurality of power supply circuits may be connected in parallel for each phase of the alternating current voltages having phases that are different from each other.

In the above aspect, the power supply system may further include a forcible disconnection unit configured to forcibly disconnect the battery in the battery module from the series connection regardless of the gate driving signal.

In the above aspect, the power supply system may further include a state detection unit configured to detect voltage information or temperature information of the battery included in each of the battery modules, and a battery state estimation unit configured to estimate a state of the battery using the voltage information or the temperature information. The battery in each of the battery modules may be forcibly disconnected from the series connection by the forcible disconnection unit according to the state of the battery estimated by the battery state estimation unit.

In the above aspect, the power supply system may further include a forcible connection unit configured to forcibly disconnect the battery in each of the battery modules from the series connection regardless of the gate driving signal.

In the above aspect, the power supply system may further include a state detection unit configured to detect voltage information or temperature information of the battery included in each of the battery modules, and a battery state estimation unit configured to estimate the state of the battery using the voltage information or the temperature information. The battery in each of the battery modules may be forcibly connected to the series connection by the forcible connection unit according to the state of the battery estimated by the battery state estimation unit.

With at least one aspect of the present invention, it is possible to output the alternating current voltage without using the inverter, thereby reducing a cost of the system.

With at least one aspect of the present invention, it is possible to control the switch elements of the battery modules connected in series only by the gate driving signal of each phase.

With at least one aspect of the present invention, even when the battery in the battery module fails, it is possible to continue operations of an entire system by disconnecting the failed battery in the battery module.

With at least one aspect of the present invention, it is possible to equalize a charged state even when the batteries in the battery modules have different capacities from each other.

With at least one aspect of the present invention, even when the power supply circuits constituting the system have batteries having different capacities from each other, it is possible to prevent the battery in the power supply circuit having a small remaining capacity from reaching a minimum use limit earlier, and to control the batteries such that they reach the minimum use limit at the same time in the power supply circuits of all phases, by controlling the output power of each power supply circuit according to the remaining capacity of each battery.

With at least one aspect of the present invention, even when the current amplitude of each phase of the power supply circuit is set independently, it is possible to control the current according to a grid voltage of each phase by providing a configuration with a neutral wire, thereby preventing the deterioration of a power factor.

BRIEF DESCRIPTION OF THE DRAWINGS

Features, advantages, and technical and industrial significance of exemplary embodiments of the invention will be described below with reference to the accompanying drawings, in which like signs denote like elements, and wherein:

FIG. 1 is a diagram illustrating a basic configuration of a power supply device according to an embodiment of the present invention;

FIG. 2 is a time chart describing control of a battery module according to the embodiment of the present invention;

FIG. 3A is a diagram illustrating an operation of the battery module according to the embodiment of the present invention;

FIG. 3B is another diagram illustrating the operation of the battery module according to the embodiment of the present invention;

FIG. 4 is a time chart describing control of the power supply device according to the embodiment of the present invention;

FIG. 5 is a time chart describing a specific example of forcible disconnection control according to the embodiment of the present invention;

FIG. 6 is a diagram illustrating a configuration of a three-phase alternating current power supply according to a first embodiment;

FIG. 7 is a diagram illustrating an alternating current voltage output from the three-phase alternating current power supply according to the first embodiment;

FIG. 8 is a diagram illustrating a specific exemplified configuration of the three-phase alternating current power supply according to the first embodiment;

FIG. 9 is a diagram illustrating a control block for grid interconnection control of the three-phase alternating current power supply according to the first embodiment;

FIG. 10 is a diagram illustrating a control block for the grid interconnection control of the three-phase alternating current power supply according to the first embodiment;

FIG. 11 is a diagram illustrating an operation waveform of the grid interconnection control of the three-phase alternating current power supply according to the first embodiment;

FIG. 12 is a diagram illustrating a configuration of a three-phase alternating current power supply according to a first modified example;

FIG. 13 is a diagram illustrating a control block for the grid interconnection control of the three-phase alternating current power supply according to the first modified example;

FIG. 14 is a diagram illustrating an operation waveform for the grid interconnection control of the three-phase alternating current power supply according to the first modified example;

FIG. 15 is a diagram illustrating waveforms of string phase power and total power of the grid interconnection control of the three-phase alternating current power supply according to the first modified example;

FIG. 16 is a diagram illustrating a configuration of a three-phase alternating current power supply according to a second modified example;

FIG. 17 is a diagram illustrating a configuration of a single-phase alternating current power supply according to a second embodiment;

FIG. 18 is a diagram illustrating a control block of the single-phase alternating current power supply according to the second embodiment;

FIG. 19 is a diagram illustrating an operation waveform of the single-phase alternating current power supply according to the second embodiment;

FIG. 20 is a diagram illustrating a configuration of a full-bridge battery module according to a third embodiment;

FIG. 21 is a diagram illustrating a configuration example of a power supply circuit to which the full-bridge battery module according to the third embodiment is applied;

FIG. 22 is a diagram illustrating a configuration of a three-phase alternating current power supply with a positive/negative reverse connection according to a fourth embodiment; and

FIG. 23 is a diagram illustrating a configuration of a charge/discharge system according to a fifth embodiment.

DETAILED DESCRIPTION OF EMBODIMENTS

Basic Configuration of Power Supply Circuit

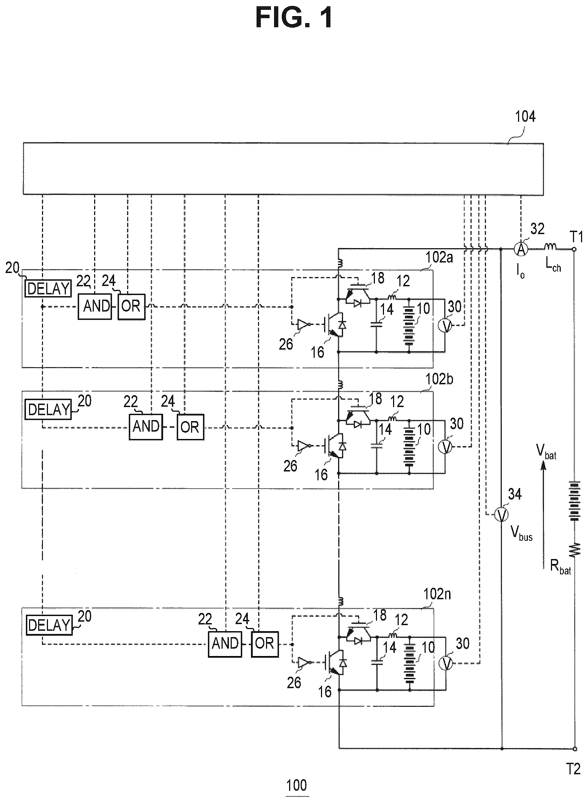

As illustrated in FIG. 1, a power supply circuit 100 according to the present embodiment includes a battery module 102, a controller 104, a current sensor 32, and a voltage sensor 34. The power supply circuit 100 includes a plurality of battery modules 102 (102a, 102b, ... , 102n). The plurality of battery modules 102 included in the power supply circuit 100 supply (power running) power to loads (not shown) connected to terminals T1 and T2, or can be charged (regeneration) from a power supply (not shown) connected to the terminals T1 and T2 (not shown). The current sensor 32 detects the current $I_o$ flowing through the power supply circuit 100. The voltage sensor 34 detects a total voltage Vbus of the plurality of battery modules 102.

The battery module 102 includes a battery 10, a choke coil 12, a capacitor 14, a voltage sensor 30, a temperature sensor (thermistor), a micro controller unit (MCU), a first switch element 16, a second switch element 18, a gate driving signal processing circuit 20, an AND element 22, an OR element 24, and a NOT element 26. In the present embodiment, each battery module 102 has the same configuration. The batteries 10 in the battery module 102 included in each power supply circuit 100 can be connected in series with each other under control of the controller 104. The voltage sensor 30, the temperature sensor, and the MCU are mounted on a cell monitoring unit (CMU).

The battery 10 includes at least one secondary battery. The battery 10 may have, for example, a configuration in which a plurality of lithium-ion batteries, nickel-metal hydride batteries, or other batteries is connected in series and/or in parallel. The choke coil 12 and the capacitor 14 form a smoothing circuit (a low-pass filter circuit) that smooths and outputs an output from the battery 10. In other words, since a secondary battery is used as the battery 10, an RLC filter is formed by the battery 10, the choke coil L, and the capacitor 14 to level the current in order to restrict the deterioration of the battery 10 due to the increased internal resistance loss. The voltage sensor 30 detects a voltage of the battery 10. The temperature sensor detects temperature of the battery 10. The MCU estimates a state of the battery such as the SOC and the power Win/out for the battery 10 based on the detected voltage and/or the detected temperature. The choke coil 12, the capacitor 14, the voltage sensor, the temperature sensor, and the MCU are not essential configurations. Therefore, these components can be omitted from the present embodiment.

The first switch element 16 includes a switch element for short-circuiting an output end of the battery 10. In the present embodiment, the first switch element 16 has a configuration in which a recirculation diode is connected in parallel with a field-effect transistor, that is, the switch element. The second switch element 18 is connected in series with the battery 10 and the first switch element 16. In the present embodiment, the second switch element 18 has a configuration in which a recirculation diode is connected in parallel with a field-effect transistor, that is, the switch element. The first switch element 16 and the second switch element 18 are switched and controlled by a gate driving signal from the controller 104. In the present embodiment, the first switch element 16 and the second switch element 18 are field-effect transistors, but other types of switch elements, such as IGBTs, may be adopted.

The gate driving signal processing circuit 20 is a circuit that controls the battery module 102 based on the gate driving signal input from the controller 104 to the battery module 102. The gate driving signal processing circuit 20 includes a delay circuit that delays the gate driving signal by a predetermined time. In the power supply circuit 100, the gate driving signal processing circuits 20 are provided in the respective battery modules 102 (102a, 102b, ... , 102n). Those circuits are connected to each other in series. Therefore, the gate driving signal input from the controller 104 is sequentially input to each battery module 102 (102a, 102b, ... , 102n) while being delayed by the predetermined time. The control based on the gate driving signal will be described below.

The AND element 22 constitutes a disconnection unit that forcibly disconnects the battery 10 in the battery module 102 from the series connection in response to a forcible disconnection signal. The OR element 24 constitutes a connection unit that forcibly connects the battery 10 in the battery module 102 to the series connection in response to a forcible connection signal. The AND element 22 and the OR element 24 are respectively controlled by receiving the forcible disconnection signal and the forcible connection signal from the controller 104. A control signal from the controller 104 is input to one input terminal of the AND element 22, and a gate driving signal from the gate driving signal processing circuit 20 is input to the other input terminal. A control signal from the controller 104 is input to one input terminal of the OR element 24, and a gate driving signal from the gate driving signal processing circuit 20 is input to the other input terminal. Output signals from the AND element 22 and the OR element 24 are input to a gate terminal of the second switch element 18. Further, the output signals from the AND element 22 and the OR element 24 are input to a gate terminal of the first switch element 16 via the NOT element 26.

At a time of the normal control, a high (H) level control signal from the controller 104 is input to the AND element 22, and a low (L) level control signal is input to the OR element 24. Therefore, the gate driving signal is directly input to the gate terminal of the second switch element 18, and a signal obtained by inverting the gate driving signal is input to the gate terminal of the first switch element 16. Consequently, the first switch element 16 is in an off state and the second switch element 18 is in an on state when the gate driving signal is at the high (H) level, and the first switch element 16 is in the on state and the second switch element 18 is in the off state when the gate driving signal is at the low (L) level. In other words, when the gate driving signal is at the high (H) level, the battery 10 in the battery module 102 turns to a state of being connected in series with the batteries 10 in the other battery modules 102, and when the gate driving signal is at the low (L) level, the battery 10 in the battery module 102 turns to a through state of being disconnected from the batteries 10 in the other battery module 102.

When forcibly disconnected, the controller 104 transmits the forcible disconnection signal to the AND element 22 and the OR element 24 of the battery module 102 to be forcibly disconnected. The low (L) level control signal (the forcible disconnection signal) is input from the controller 104 to the AND element 22, and the low (L) level control signal (the forcible disconnection signal) is input to the OR element 24. Consequently, the low (L) level signal is output from the AND element 22, the high (H) level signal is input to the gate terminal of the first switch element 16 by the NOT element 26 via the OR element 24, and the low (L) level signal is input to the gate terminal of the second switch element 18. Therefore, the first switch element 16 is always in the on state, the second switch element 18 is always in the off state, and the battery 10 in the battery module 102 is forcibly disconnected from the series connection regardless of the gate driving signal (a pass-through state).

Such forcible disconnection control can be used for controlling an SOC imbalance of the batteries 10 in the battery modules 102 of the power supply circuit 100. That is, in a case where the power supply circuit 100 is in a discharged state, the SOC of the battery 10 in the battery module 102 involved in the output of the power supply circuit 100 decreases, whereas the battery 10 in the battery module 102 is forcibly disconnected to maintain the SOC of the battery 10 in the battery module 102. Further, in a case where the power supply circuit 100 is in the charged state, the SOC of the battery 10 in the battery module 102 involved in the charging of the power supply circuit 100 increases, whereas the battery 10 in the battery module 102 is forcibly disconnected to maintain the SOC of the battery 10 in the battery module 102.

When forcibly connected, the controller 104 transmits the forcible connection signal to the AND element 22 and the OR element 24 of the battery module 102 to be forcibly connected. The high (H) level control signal (forcible connection signal) is input from the controller 104 to the OR element 24 of the battery module 102. Consequently, the high (H) level signal is output from the OR element 24, the low (L) level signal is input to the gate terminal of the first switch element 16 by the NOT element 26 via the OR element 24, and the high (H) level signal is input to the gate terminal of the second switch element 18. Therefore, the first switch element 16 is always in the off state, the second switch element 18 is always in the on state, and the battery 10 in the battery module 102 is forcibly connected to the series connection regardless of the gate driving signal.

Such forcible connection control can be used for controlling the SOC imbalance of the batteries 10 in the battery modules 102 of the power supply circuit 100. That is, in a case where the power supply circuit 100 is in the discharged state, it is possible to lower the SOC of the battery 10 in the battery module 102 forcibly connected more quickly than the SOC of the battery 10 in the battery module 102 intermittently connected in series according to the gate driving signal. In a case where the power supply circuit 100 is in the charged state, it is possible to increase the SOC of the battery 10 in the battery module 102 forcibly connected more quickly than the SOC of the battery 10 in the battery module 102 intermittently connected in series according to the gate driving signal.

The power supply circuit 100 in the present embodiment is configured to directly control either the AND element 22 or the OR element 24, or both, by the controller 104, but a configuration may be modified such that the AND element 22 and the OR element 24 are controlled by the controller 104 via the gate driving signal processing circuit 20.

Normal Control

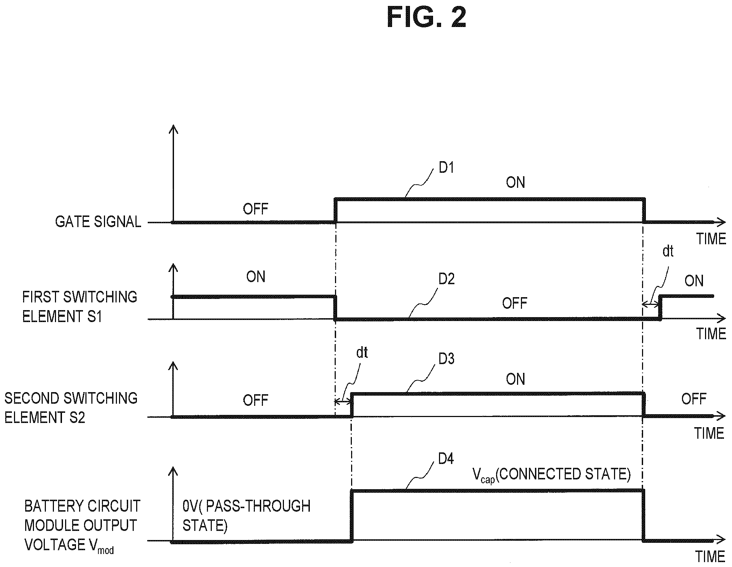

Hereinafter, the control of the power supply circuit 100 will be described with reference to FIG. 2. At the time of the normal control, the high (H) level control signal is input from the controller 104 to the AND element 22 of each battery module 102 (102a, 102b, ... , 102n). The low (L) level control signal is input from the controller 104 to the OR element 24 of each battery module 102 (102a, 102b, ... , 102n). Therefore, the gate driving signal from the gate driving signal processing circuit 20 is input as an inverting signal to the gate terminal of the first switch element 16 via the NOT element 26, and the gate driving signal from the gate driving signal processing circuit 20 without any change (as it is) is input to the gate terminal of the second switch element 18.

FIG. 2 illustrates a time chart regarding an operation of a battery module 102a. FIG. 2 denotes a pulse waveform of a gate driving signal D1 for driving the battery module 102a, a square wave D2 indicating a switching state of the first switch element 16, a square wave D3 indicating a switching state of the second switch element 18, and a waveform D4 of a voltage $V_{mod}$ output by the battery module 102a.

In an initial state of the battery module 102a, that is, in a state where the gate driving signal is not output, the first switch element 16 is in the on state, and the second switch element 18 is in the off state. When the gate driving signal is input to the battery module 102a from the controller 104, the battery module 102a is switched and controlled by PWM control. In this control, the first switch element 16 and the second switch element 18 are alternately switched to the on/off state.

As illustrated in FIG. 2, when the gate driving signal D1 is output from the controller 104, the first switch element 16 and the second switch element 18 of the battery module 102a are driven in response to the gate driving signal D1. The first switch element 16 is switched from the on state to the off state by a falling edge of the signal from the NOT element 26 in response to a rising edge of the gate driving signal D1. The first switch element 16 is switched from the off state to the on state with a slight delay (a dead time dt) from the falling edge of the gate driving signal D1.

Meanwhile, the second switch element 18 is switched from the off state to the on state with a slight delay (the dead time dt) from the rising edge of the gate driving signal D1. The second switch element 18 is switched from the on state to the off state at the same time as when the gate driving signal D1 falls. Accordingly, the first switch element 16 and the second switch element 18 are controlled to be alternately switched to the on/off state.

The first switch element 16 operates with a slight delay (the dead time dt) when the gate driving signal D1 falls, and the second switch element 18 operates with a slight delay (the dead time dt) when the gate driving signal D1 rises. The delayed operations are to prevent the first switch element 16 and the second switch element 18 from being turned on at the same time. That is, it is possible to prevent the first switch element 16 and the second switch element 18 from being turned on at the same time and the battery 10 from being short-circuited. The dead time dt that delays the operation is set to, for example, 100 nanoseconds, but it can be set as appropriate. During the dead time dt, the current circulates through the diode, and the switch element in parallel with the circulated diode is in the same state as when it is turned on.

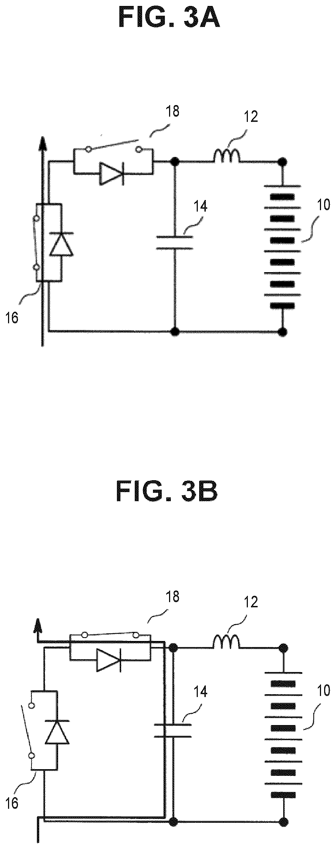

By such control, when the gate driving signal D1 is OFF (that is, the first switch element 16 is turned on and the second switch element 18 is turned off), the capacitor 14 and the battery 10 are disconnected from an output terminal of the battery module 102a. Therefore, no voltage is output from the battery module 102a to the output terminal. As illustrated in FIG. 3A, the battery 10 (the capacitor 14) of the battery module 102a turns to a bypassed through state.

On the other hand, when the gate driving signal D1 is ON (that is, the first switch element 16 is turned off and the second switch element 18 is turned on), the capacitor 14 and the battery 10 are connected to the output terminal of the battery module 102a. Therefore, a voltage is output from the battery module 102a to the output terminal. As illustrated in FIG. 3B, the voltage $V_{mod}$ is output to the output terminal via the capacitor 14 in the battery module 102a.

Returning to FIG. 1, the control of the power supply circuit 100 by the controller 104 will be described. The controller 104 controls the entire battery module 102. That is, the output voltage of the power supply circuit 100 is controlled by controlling the plurality of battery modules 102a, 102b, ... , 102n.

The controller 104 outputs a rectangular wave gate driving signal to each battery module 102. The gate driving signal is sequentially transmitted to the next-stage battery module 102, that is, transmitted to the gate driving signal processing circuit 20 included in the battery module 102a, the gate driving signal processing circuit 20 included in the battery module 102b, and so on. In other words, the gate driving signal is delayed by a predetermined delay time in order from the most upstream side of the battery modules 102 connected in series in the power supply circuit 100, and is transmitted to the downstream side.

At the time of the normal control, the high (H) level control signal is input to the AND element 22, and the low (L) level control signal is input to the OR element 24, whereby the gate driving signal output from the gate driving signal processing circuit 20 of each battery module 102 is directly input to the gate terminal of the second switch element 18, and a signal obtained by inverting the gate driving signal is input to the gate terminal of the first switch element 16. Consequently, the first switch element 16 is in the off state and the second switch element 18 is in the on state when the gate driving signal is at the high (H) level, and the first switch element 16 is in the on state and the second switch element 18 is in the off state when the gate driving signal is at the low (L) level.

In other words, when the gate driving signal is at the high (H) level, the capacitor 14 and battery 10 in the battery module 102 are in the state of being connected in series with the capacitors 14 and the batteries 10 in the other battery modules 102 (connected state), and when the gate driving signal is at the low (L) level, the capacitor 14 and the battery 10 in the battery module 102 are in the through state of being disconnected from the capacitors 14 and the batteries 10 in the other battery module 102.

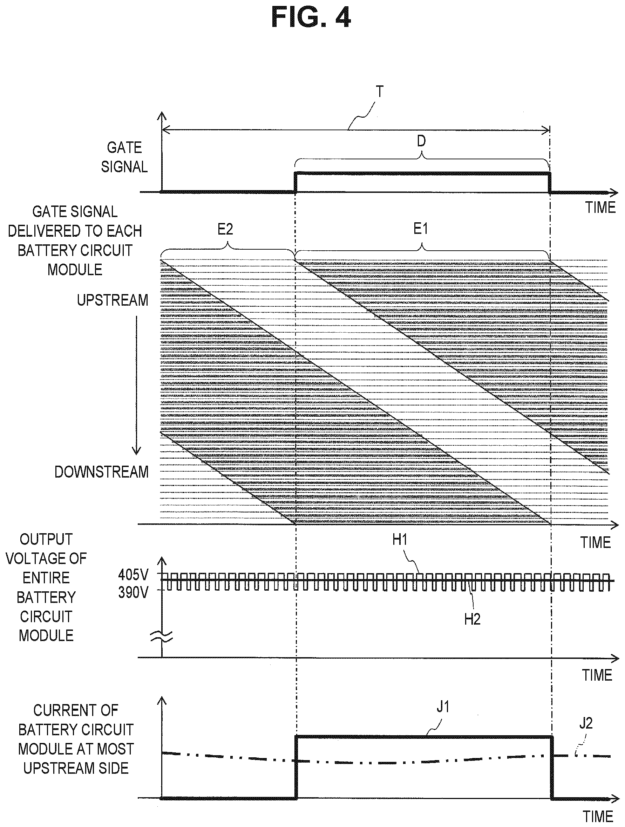

FIG. 4 illustrates a control sequence in which a predetermined number of battery modules 102a, 102b, ... , 102n are sequentially operated in a connected state to output power. As illustrated in FIG. 4, the battery modules 102a, 102b, ... , 102n are driven one after another from the upstream side to the downstream side with a constant delay time according to the gate driving signal. In FIG. 4, during a period E1, the first switch element 16 is turned off and the second switch element 18 is turned on in each of the battery modules 102a, 102b, ... , 102n, and the battery modules 102a, 102b, ... , 102n output the voltage from the output terminals (the connected state). During a period E2, the first switch element 16 is turned on and the second switch element 18 is turned off in each of the battery modules 102a, 102b, ... , 102n, and the battery modules 102a, 102b, ... , 102n do not output the voltage from the output terminals (the through state). The battery modules 102a, 102b, ... , 102n are sequentially driven with a constant delay time.

The gate driving signal and the delay time will be described with reference to FIG. 4. A period T of the gate driving signal is set by summing the delay times of the battery modules 102a, 102b, ... , 102n. Therefore, the longer the delay time, the lower the frequency of the gate driving signal. In contrast, the shorter the delay time, the higher the frequency of the gate driving signal. Setting the frequency (a switching frequency) will be described below.

Hereinafter, for simpler description, a case where the forcible disconnection and the forcible connection are not executed for each battery module 102 will be described. An on-time ratio D (on-duty) in the period T of the gate driving signal, that is, a ratio of a time $T_{ON}$ from when the gate driving signal is at the high (H) level to a period T is calculated by an output voltage of the power supply circuit 100/total voltage of the battery modules 102a, 102b, ... , 102n (the battery voltage of the battery module 102 $\times$ the number of battery modules in a case where the battery voltage of each battery module 102 is equal). That is, the on-time ratio D = (output voltage of the power supply circuit 100)/(battery voltage of the battery module 102 $\times$ total number of battery modules 102). Since the on-time ratio shifts by the dead time dt, the on-time ratio may be corrected by feedback or feedforward in a similar manner that is generally executed in a chopper circuit.

As described above, the output voltage of the power supply circuit 100 is represented by a value obtained by multiplying the battery voltage of the battery modules 102 by the number of connected battery modules 102 in a case where the battery voltages of the battery modules 102 are equal. When the output voltage of the power supply circuit 100 is a value dividable by the battery voltage of each battery module 102, the other battery module 102 is switched from the connected state to the through state at the moment when another battery module 102 is switched from the through state to the connected state. Therefore, there is no fluctuation in the entire output voltage of the battery module 102.

However, when the output voltage of the power supply circuit 100 is a value that is not dividable by the battery voltage of each battery module 102, the output voltage of the power supply circuit 100 (entire output voltage) fluctuates. However, the fluctuation amplitude at this time is the voltage for one battery module, and this fluctuation cycle is represented by a cycle T of the gate driving signal/the total number of the battery modules 102. Since the fluctuation cycle can be shortened by increasing the total number of battery modules 102 and a parasitic inductance of the entire power supply circuit 100 can be set to a high value, this voltage fluctuation is filtered and the output voltage of the power supply circuit 100 is stabilized.

Specific examples will be described hereinbelow. In FIG. 4, for example, a desired output voltage of the power supply circuit 100 is 400 V, the battery voltage of each battery module 102 is 15 V, the number of battery modules 102a, 102b, ..., 102n is 40, and the delay time is 200 nanoseconds. In this case, the output voltage (400V) of the power supply circuit 100 is not dividable by the battery voltage (15V) of the battery module 102.

Based on these numerical values, the period T of the gate driving signal is calculated by multiplying the delay time by the total number of battery modules, i.e., 200 ns $\times$ 40 = 8 $\mu$s. Therefore, the gate driving signal is a rectangular wave having a frequency equivalent to 125 kHz. Since the on-time ratio D of the gate driving signal is calculated by the output voltage of the power supply circuit 100 / (the battery voltage of the battery module 102 $\times$ the total number of battery modules 102), the on-time ratio D is 400V/(15V $\times$ 40 units) $\approx$ 0.67.

When the battery modules 102a, 102b, ... , 102n are sequentially driven based on these numerical values, a rectangular wave-shaped output voltage H1 is obtained as the power supply circuit 100, as illustrated in FIG. 4. This output voltage H1 fluctuates between 390V and 405V That is, the output voltage H1 fluctuates in a cycle calculated by the cycle T of the gate driving signal/the total number of battery modules, i.e., 8 $\mu$s/40 units = 200 ns (equivalent to 5 MHz). This fluctuation is filtered by the parasitic inductance due to wiring of the battery modules 102a, 102b, ... , 102n, and approximately 400V is output as an output voltage H2 for the entire power supply circuit 100.

A current flows through the second switch element 18 of each battery module 102 in the connected state, and as illustrated in FIG. 4, a current waveform J1 of the second switch element 18 is a square wave. Since the battery 10 and the capacitor 14 form the RLC filter, a filtered and leveled current J2 flows through the battery 10 in each battery module 102. As described above, the current waveforms are uniform in all the battery modules 102a, 102b, ... , 102n, and the current can be uniformly output from all the battery modules 102a, 102b, ... , 102n.

As described above, when the power supply circuit 100 is controlled, the gate driving signal output to the battery module 102a on the most upstream side is output to the battery module 102b on the downstream side with a certain delay time, and further, this gate driving signal is delayed for a certain period of time and sequentially transmitted to the battery module 102 on the downstream side. Therefore, the battery modules 102a, 102b, ... , 102n sequentially output the voltage while being delayed for a certain period of time. The voltage output from the power supply circuit 100 is obtained by summing these voltages. Consequently, the desired voltage can be output from the power supply circuit 100.

According to the power supply circuit 100, the DC/DC converter is not required, and thus the circuit configuration can be simplified. A balance circuit causing power loss is also unnecessary, and the efficiency of the power supply circuit 100 can be improved. Since the voltage is output almost evenly from the plurality of battery modules 102a, 102b, ... , 102n, the driving does not rely on the specific battery module 102, and internal resistance loss of the power supply circuit 100 can be reduced.

By adjusting the on-time ratio D, it is possible to generate the desired output voltage equal to or less than the sum of the battery voltages, and the power supply circuit 100 can have improved versatility.

Forcible Disconnection Control

Control for forcibly disconnecting the battery 10 in the battery module 102, selected from the plurality of battery modules 102 (102a, 102b, ... , 102n) will be described hereinbelow. The controller 104 outputs the forcible disconnection signal to the AND element 22 and the OR element 24 of the battery module 102 to be forcibly disconnected. That is, the low (L) level control signal is output to the AND element 22, and the low (L) level control signal is output to the OR element 24, included in the battery module 102 to be forcibly disconnected. Consequently, the low (L) level signal is output from the AND element 22, the high (H) level signal is input to the gate terminal of the first switch element 16 by the NOT element 26 via the OR element 24, and the low (L) level signal is input to the gate terminal of the second switch element 18. Therefore, the first switch element 16 is always in the on state, the second switch element 18 is always in the off state, and the battery 10 in the specific battery module 102 is forcibly disconnected regardless of the gate driving signal (the pass-through state). With such forcible disconnection control, it is possible to continue the operation by disconnecting the battery 10 in the specific battery module 102 when the battery 10 fails. The on-time ratio D in a case of the forcible disconnection is represented by (the output voltage of the power supply circuit 100)/(the total voltage of the battery module 102 excluding the battery module 102 forcibly disconnected). When the battery 10 in any one of the battery modules 102a, 102b, ... , 102n fails, the failed battery 10 is excluded. The period T and the on-time ratio D of the gate driving signal are reset with the normal battery modules 102 only, and thus the desired voltage can be obtained. That is, even when the battery 10 in any one of the battery modules 102a, 102b, ... , 102n fails, the desired voltage can be continuously output. In a case where the battery capacity of each battery module 102 varies, it can be used for control for restricting the SOC imbalance of the batteries 10 in the battery modules 102.

For example, in a case where the power supply circuit 100 is in a power running state, the battery 10 in the battery module 102 having a relatively low SOC is forcibly disconnected, from among the batteries 10 in the battery module 102 included in the power supply circuit 100. A power consumption (an integrated amount of discharge current per unit time) of the battery 10 forcibly disconnected is reduced, and the SOC imbalance of the batteries 10 in the battery modules 102 can be eliminated. Consequently, the SOC of the battery 10 in the battery module 102 can be close to an SOC control target value. Charging energy of the battery 10 in each battery module 102 can be efficiently exhausted.

It is also possible to execute control for eliminating the SOC imbalance of the batteries 10 in the battery modules 102 in a regeneration state instead of the power running state. In this case, the battery module is controlled by forcibly disconnecting the battery 10 in the battery module 102 having a relatively high SOC, and preferentially regenerating the power to the battery 10 in the battery module 102 having a relatively low SOC, thus the SOC imbalance of the batteries 10 in the battery modules 102 can be eliminated. That is, the power supply (the integrated amount of charge current per unit time) to the battery 10 in the battery module 102 having a relatively high SOC is reduced, from among the batteries 10 in the battery module 102, thus the SOC imbalance of the batteries 10 in the battery modules 102 can be eliminated. Consequently, the SOC of the battery 10 in the battery module 102 can be close to the SOC control target value. In addition, the batteries 10 in all the battery modules 102 included in the power supply circuit 100 can be charged in a well-balanced manner. It is also possible to prevent the battery 10 in the battery module 102 having a small charging capacity from being overcharged.

Forcible Connection Control

Control for forcibly connecting the battery 10 in the battery module 102, selected from the plurality of battery modules 102 (102a, 102b, ... , 102n) will be described hereinbelow. The controller 104 outputs the forcible connection signal to the OR element 24 of the battery module 102 to be forcibly connected. That is, the high (H) level control signal is output to the OR element 24 included in the battery module 102 to be forcibly connected.

Consequently, the high (H) level signal is output from the OR element 24, the low (L) level signal is input to the gate terminal of the first switch element 16 by the NOT element 26 via the OR element 24, and the high (H) level signal is input to the gate terminal of the second switch element 18. Therefore, the first switch element 16 is always in the off state, the second switch element 18 is always in the on state, and the battery 10 in the battery module 102 is forcibly connected to the series connection regardless of the gate driving signal. Such forcible connection control can be used for controlling the SOC imbalance of the batteries 10 in the battery modules 102 of the power supply circuit 100.

For example, in a case where the power supply circuit 100 is in the regeneration state, the battery 10 in the battery module 102 having a relatively low SOC is forcibly connected, from among the batteries 10 in the battery module 102 included in the power supply circuit 100, and preferentially charged by the regenerative power. The integrated amount of charge current per unit time of the battery 10 forcibly disconnected is increased, and the SOC imbalance of the batteries 10 in the battery modules 102 can be eliminated. Consequently, the SOC of the battery 10 in the battery module 102 can be close to the SOC control target value. In addition, the batteries 10 in all the battery modules 102 included in the power supply circuit 100 can be charged in a well-balanced manner.

It is also possible to execute the control for eliminating the SOC imbalance of the batteries 10 in the battery modules 102 included in the power supply circuit 100 in the power running state instead of the regeneration state. In this case, the battery module is controlled by forcibly connecting the battery 10 in the battery module 102 having a relatively high SOC, and increasing the power consumption of the battery 10 in the battery module 102 having a relatively high SOC, and thus the SOC imbalance of the batteries 10 in the battery modules 102 can be eliminated. That is, the power supply (the integrated amount of discharge current per unit time) from the battery 10 in the battery module 102 having a relatively high SOC is increased, from among the batteries 10 in the battery module 102, thus the SOC imbalance of the batteries 10 in the battery modules 102 can be eliminated. Consequently, the SOC of the battery 10 in the battery module 102 can be close to the SOC control target value. The charging energy of the batteries 10 in all the battery modules 102 included in the power supply circuit 100 can be efficiently exhausted.

Specific Example of Forcible Disconnection Control

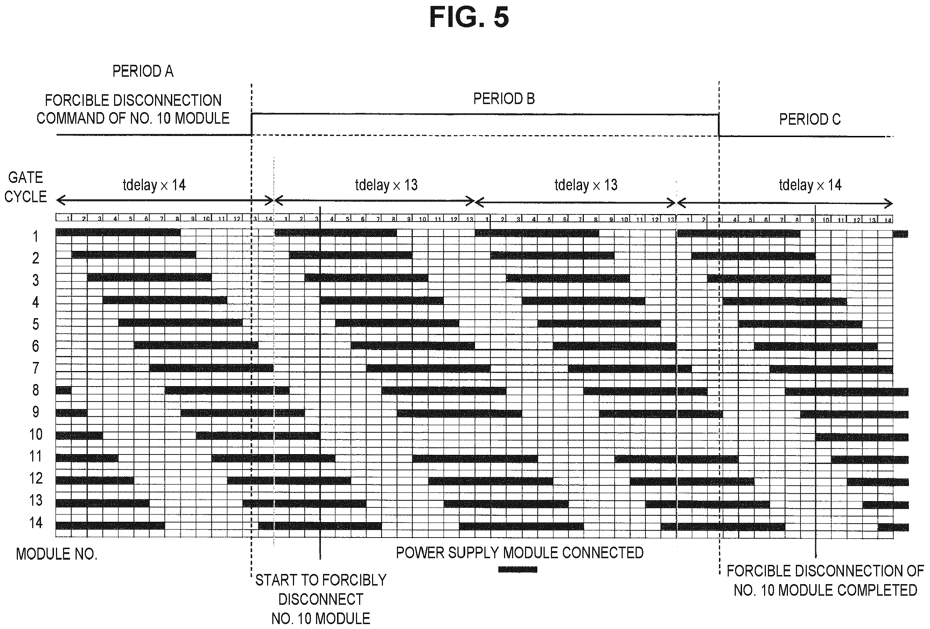

FIG. 5 illustrates a specific exemplified time chart illustrating a connection state of each battery 10 in the battery module 102 of the power supply circuit 100 to which the forcible disconnection control is applied. For simpler description, a case where 14 battery modules 102 are used is described as a specific example.

In a period A, a forcible disconnection command for all the battery modules 102 is turned off, and all the battery modules 102 are switched and controlled. In a case where the forcible disconnection command is off in each battery module 102, the gate driving signal is delayed by a delay time $t_{delay}$ and transmitted to the next battery module 102. Therefore, a gate cycle is (delay time $t_{delay} \times 14$).

In the gate driving signal from the controller 104, the delay time is set to $t_{delay} \times 8$ as the on-time, and the 8 battery modules 102 are controlled to be connected at the same time.

On the other hand, in a period B, the forcible disconnection signal for the tenth battery module 102 from the upstream is turned on. Accordingly, the output voltage of the tenth battery module 102 becomes 0V. Further, the gate driving signal processing circuit 20 accompanying the tenth battery module 102 does not delay the gate driving signal and propagates to the next eleventh battery module 102. A cycle until the rising edge of the gate driving signal output from the controller 104 returns to the controller 104 is equal to the delay time $t_{delay} \times 13$, which is shortened by the delay time $t_{delay} \times 1$. The controller 104 detects the returned rising edge of the gate driving signal, and outputs a signal that is turned on by the delay time $t_{delay} \times 8$ as the next gate driving signal. During the period B, 8 battery modules 102 are always connected in series to output the voltage for the load. That is, the same voltage in the period A can be output in the period B.

When the tenth battery module 102 receives the forcible disconnection signal, a timing at which the tenth battery module 102 is disconnected regardless of the gate driving signal is set after the gate driving signal is turned off. That is, even when the battery module 102 receives the forcible disconnection signal while the battery module 102 is in the connected state, the forcible disconnection control is executed after the gate driving signal is turned off but it is not executed while the gate driving signal is turned on. The forcible disconnection state is maintained even when the gate driving signal is turned on in the next cycle.

When the period is shifted to a period C and the forcible disconnection signal of the tenth battery module 102 is turned off, normal switching control according to the gate driving signal is resumed in the tenth battery module 102. However, even when the forcible disconnection signal is turned off at the timing when the gate driving signal for the tenth battery module 102 is turned on, the batteries 10 in the battery module 102 are not immediately connected in series. The normal switching control resumes after the gate driving signal is turned off. Accordingly, it is possible to prevent the 9 battery modules 102 from being momentarily connected to the load.

First Embodiment (Three-phase Alternating Current Power Supply)

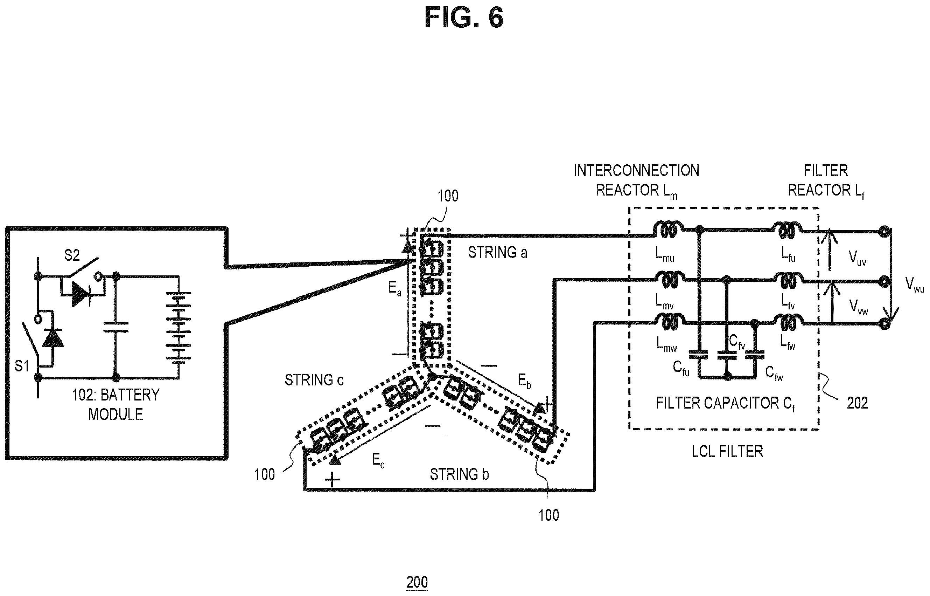

FIG. 6 illustrates a configuration of a three-phase alternating current power supply 200 using the power supply circuit 100. The three-phase alternating current power supply 200 is configured by combining three sets of power supply circuits 100.

The three sets of power supply circuits 100 (string a, string b, string c) are Y-connected such that output voltage polarities of the strings are the same at the neutral point. In FIG. 6, negative electrode sides of the three sets of power supply circuits 100 (string a, string b, string c) are connected to the neutral point, but the positive electrode sides of all the strings may be connected to the neutral point.

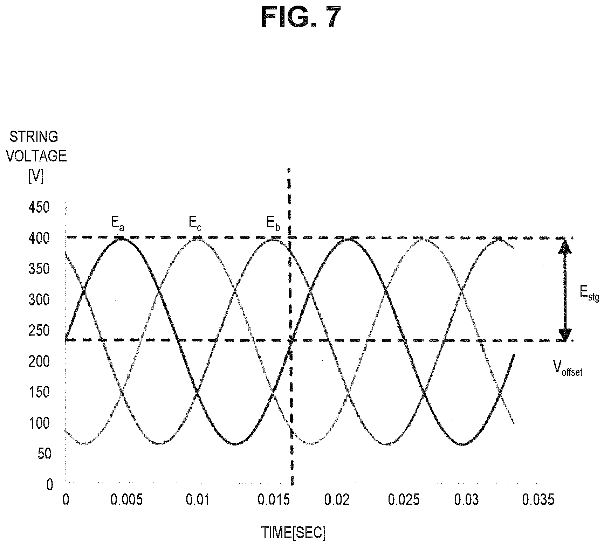

In the three-phase alternating current power supply 200, alternating current voltages $E_a$, $E_b$, $E_c$ are generated by controlling the number of connected batteries 10 in the battery module 102 in each of the three sets of power supply circuits 100, the strings a to c, respectively. Since each of the power supply circuits 100 can generate only a voltage of at least 0V, as illustrated in FIG. 7, the alternating current voltages $E_a$, $E_b$, $E_c$ have offsets, and each of them generates a voltage having a different phase from each other by 120°.

By generating the alternating current voltage having the same offset voltage in each of the strings a to c, it is possible to generate positive and negative alternating current voltages having an average voltage of 0V in line voltages $V_{uv}$, $V_{vw}$, $V_{wu}$. Accordingly, the manufacturing cost can be reduced by using a half-bridge circuit without using a full-bridge circuit with four switches in the battery module 102 included in the power supply circuit 100.

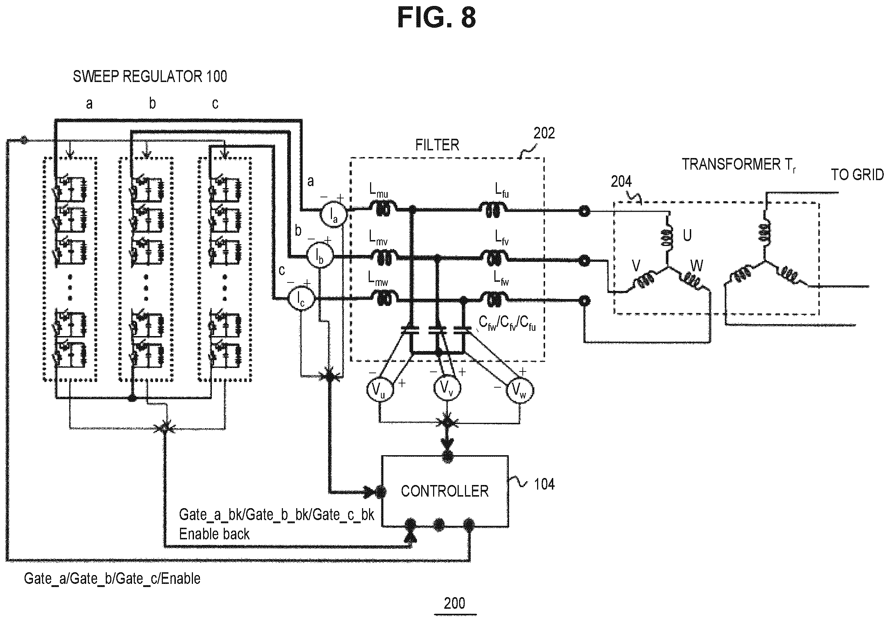

Output ends of the strings a to c are connected to a filter 202. As illustrated in FIG. 8, the filter 202 can be configured by including interconnection reactors $L_m$ ($L_{mu}$, $L_{mv}$, $L_{mw}$), filter capacitors $C_f$ ($C_{fu}$, $C_{fv}$, $C_{fw}$), and filter reactors $L_f$ ($L_{fu}$, $L_{fv}$, $L_{fw}$). The filter 202 is provided in each phase of the strings a to c. The filter capacitor is connected to the neutral point. An output side of the filter 202 is connected to a secondary side of a transformer 204. A relay may be provided between the filter 202 and the transformer 204.

Further, current sensors ($I_a$, $I_b$, $I_c$) are provided to measure the output currents of the strings a to c. Only two phases of the current sensor may be installed, and the remaining one phase may be calculated from the measured two-phase currents. For example, while an a-phase current $I_a$ and a b-phase current $I_b$ are measured, a c-phase current $I_c$ can be calculated by the equation (1):

[Equation 1]

$$I_c = -I_a - I_b \quad \cdots (1)$$

Voltage sensors ($V_u$, $V_v$, $V_w$) for measuring the voltages of the three filter capacitors in the filter 202 are provided. By measuring the filter capacitor voltage, the voltage of each phase voltage of a grid can be measured.

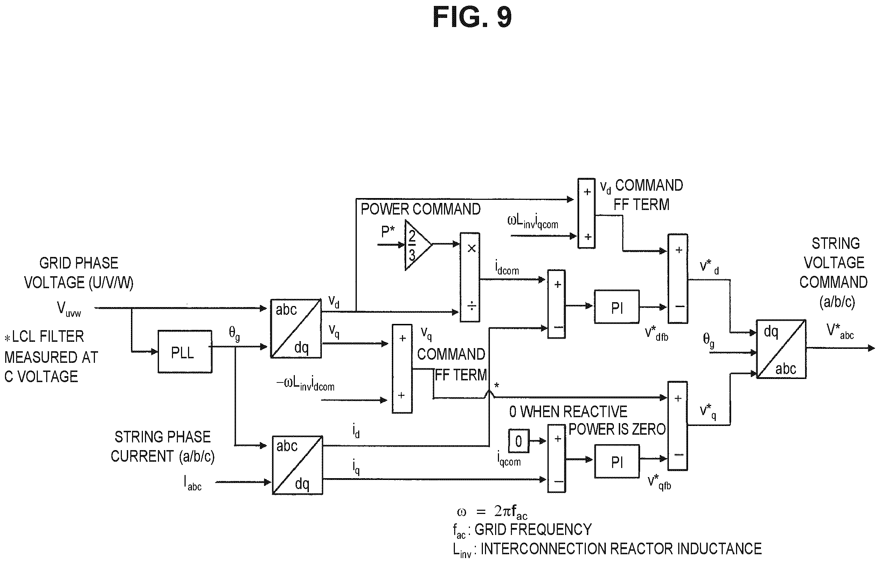

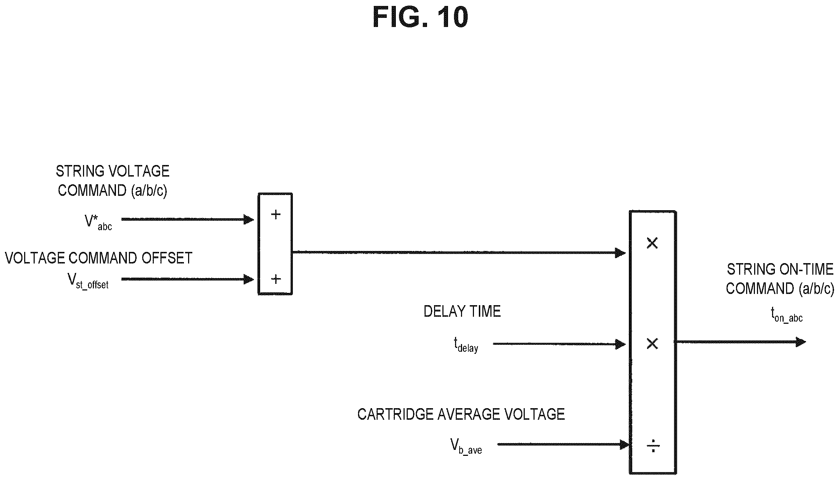

Hereinafter, details of grid interconnection control of the three-phase alternating current power supply 200 will be described. FIGS. 9 and 10 illustrate block diagrams of the grid interconnection control.

In FIG. 9, calculation for voltage command values of the strings a to c will be described. First, a phase θg of a grid voltage is calculated by Phase Locked Loop (PLL) using the measured values $V_u$, $V_v$, $V_w$, which are grid phase voltages measured by the voltage sensors provided in the three filter capacitors $C_{fu}$, $C_{fv}$, $C_{fw}$ of the filter 202.

dq-axis voltages $v_d$, $v_q$ are calculated by executing abc/dq conversion using the voltage phase θg and the grid phase voltages $V_u$, $V_v$, $V_w$. abc/dq0 conversion can be executed by the equations (2) and (3). The grid phase voltages $V_u$, $V_v$, $V_w$ are substituted for $u_a$, $u_b$, $u_c$ in the equation (2).

[Equation 2]

$$\begin{pmatrix} u_d \\ u_q \\ u_0 \end{pmatrix} = \frac{2}{3} \begin{pmatrix} sin\theta_a & sin\theta_b & sin\theta_c \\ cos\theta_a & cos\theta_b & cos\theta_c \\ \frac{1}{2} & \frac{1}{2} & \frac{1}{2} \end{pmatrix} \begin{pmatrix} u_a \\ u_b \\ u_c \end{pmatrix} \quad \cdots (2)$$

[Equation 3]

$$\theta_a = \theta_g$$

$$\theta_b = \theta_g - \frac{2}{3}\pi \quad \cdots (3)$$

$$\theta_c = \theta_g + \frac{2}{3}\pi$$

dq-axis currents $i_d$, $i_q$ can be calculated by substituting the output currents $I_a$, $I_b$, $I_c$ of the strings a to c for $u_a$, $u_b$, $u_c$ of the equation (2) and executing the dq conversion.

Next, a current command value of the dq-axis is obtained. When a command power P is for the entire three-phase alternating current power supply 200, a d-axis command current $i_{dcom}$ is calculated from the equation (4) using a d-axis voltage $v_d$ and the command power P. A q-axis current command value $i_{qcom}$ is set to zero in a case where a reactive power is controlled to zero.

[Equation 4]

$$i_{dcom} = \frac{2}{3}\frac{P}{V_d} \quad \cdots \quad (4)$$

dq-axis command voltage feedback terms $v_{dfb}^*$ and $v_{qfb}^*$ are calculated by PI control using the dq-axis command currents $i_{dcom}$, $i_{qcom}$ and dq-axis currents $i_d$, $i_q$. By adding these feedback terms to a $v_d$ command feedforward term and a $v_q$ command feedforward term, dq-axis voltage command values $v_d^*$, $v_q^*$ are calculated. Further, string voltage command values $V_a^*$, $V_b^*$, $V_c^*$ are calculated by converting the dq-axis to a three-phase abc axis. The equation (5) may be used for the dq/abc conversion.

[Equation 5]

$$\begin{pmatrix} u_a \\ u_b \\ u_c \end{pmatrix} = \begin{pmatrix} sin\theta_a & cos\theta_a & 1 \\ sin\theta_b & cos\theta_b & 1 \\ sin\theta_c & cos\theta_c & 1 \end{pmatrix} \begin{pmatrix} u_d \\ u_q \\ u_0 \end{pmatrix} \quad \cdots \quad (5)$$

Next, using the string voltage command values, on-time command values of the power supply circuit 100 for the a-phase, b-phase, c-phase are calculated using the equation (6).

[Equation 6]

$$t_{on\_abc} = \left(V^*_{abc} + V_{st_{offset}}\right) \times \frac{t_{delay}}{V_{bave_{abc}}} \quad \cdots \quad (6)$$

$V^*_{abc}$ is any of the voltage command values of a-phase, b-phase, c-phase, Vst offset is a voltage command offset value, $t_{delay}$ is a delay time of a Gate signal in each power supply circuit module, and $V_{b\_ave\_abc}$ is an average voltage of each battery module of any one of the strings a, b, c, each of which is the power supply circuit 100. An offset value to be added to each of the voltage command values of the strings a, b, c may be set to the same value for the a-phase, b-phase, c-phase.

The gate driving signals (signal Gate_a, signal Gate b, signal Gate_c) with an on-period in which only the on-time command value calculated using the equation (6) is present and an off-period thereafter are given to the first battery module 102 in each of the strings a, b, c, each of which is the power supply circuit 100.

Switching control is executed in each of the battery modules 102 based on the gate driving signal. That is, the first switch element 16 is in the off state and the second switch element 18 is in the on state during which the gate driving signal is turned on, and the first switch element 16 is in the on state and the second switch element 18 is in the off state during which the gate driving signal is turned off. The gate driving signal is delayed by a delay circuit included in the gate driving signal processing circuit 20 for a certain period of time (delay time $t_{delay}$), and then delivered to the next battery module 102. After the switching control is executed for the battery modules 102 included in each of the strings a, b, c, which is the power supply circuit 100, the gate driving signal from the last battery module 102 is returned to the controller 104.

Upon receiving the returned gate driving signal, the controller 104 transmits the gate driving signal of the next cycle using the method described in Japanese Unexamined Patent Application Publication No. 2018-174626. Specifically, the rising edge of the gate driving signal (signal Gate_a_bk, signal Gate_b_bk, signal Gate_c_bk) returned from the battery module 102 in the final stage is detected, and the next gate driving signal is output to the first-stage battery module 102. Consequently, the next gate driving signal can be transmitted to the battery module 102 at an appropriate timing.

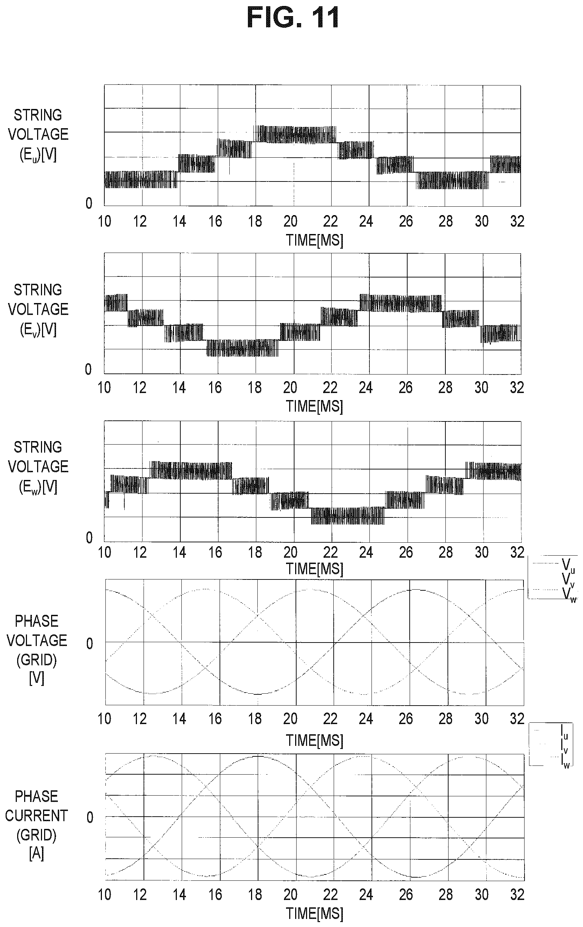

FIG. 11 illustrates an operation waveform of the grid interconnection control by the three-phase alternating current power supply 200. In the three-phase alternating current power supply 200, the power supply circuits 100 are combined to generate an alternating current voltage, thus a current can flow while a power factor is substantially one.

In the three-phase alternating current power supply 200, it is possible to generate a three-phase alternating current voltage by switching and controlling the multi-series battery modules 102 for each of the three power supply circuits 100 by using only the gate driving signal. Therefore, the controller 104 can be simplified and the cost can be reduced. Further, since each of the battery modules 102 uses only two switch elements (the first switch element 16 and the second switch element 18), the circuit cost can be reduced.

First Modified Example

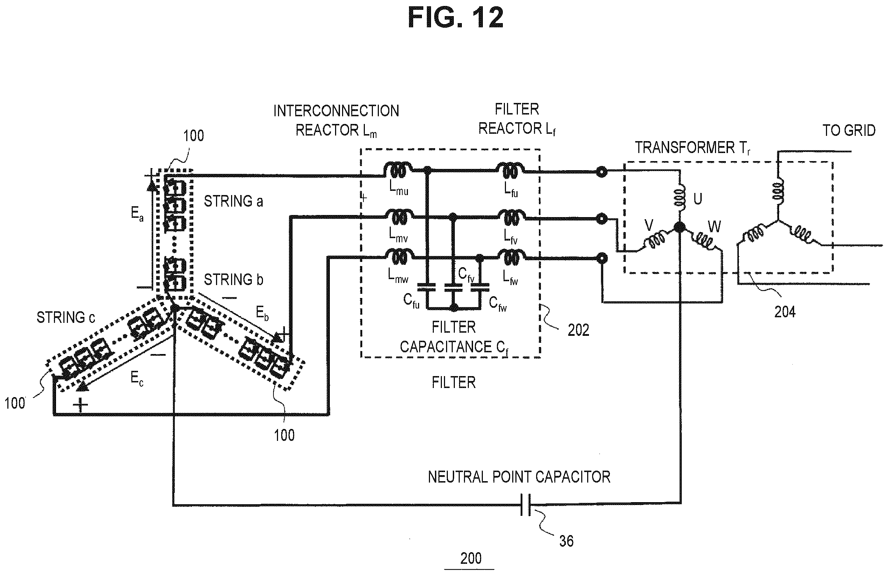

In the first modified example, as illustrated in FIG. 12, neutral points of the 3 power supply circuits 100 are Y-connected in the three-phase alternating current power supply 200 and secondary side neutral points of the transformer 204 arranged on the load side are connected via a neutral point capacitor 36. The three-phase alternating current power supply 200 in the first modified example has a three-phase four-wire configuration.

With such a configuration, even when the string current amplitude of each phase consisting of the strings a, b, c (the power supply circuit 100) is unbalanced, it is possible to control the grid phase voltage such that it matches a phase in all phases. Therefore, the power of each of the strings a, b, c can be adjusted individually without deterioration of the power factor. Accordingly, even when there is a difference in the amount of power that can be stored in the strings a, b, c when the three-phase alternating current power supply 200 is configured by using the batteries 10 having different characteristics (such as used batteries), the output power of each phase of the strings a, b, c can be adjusted to extract all the stored energy.

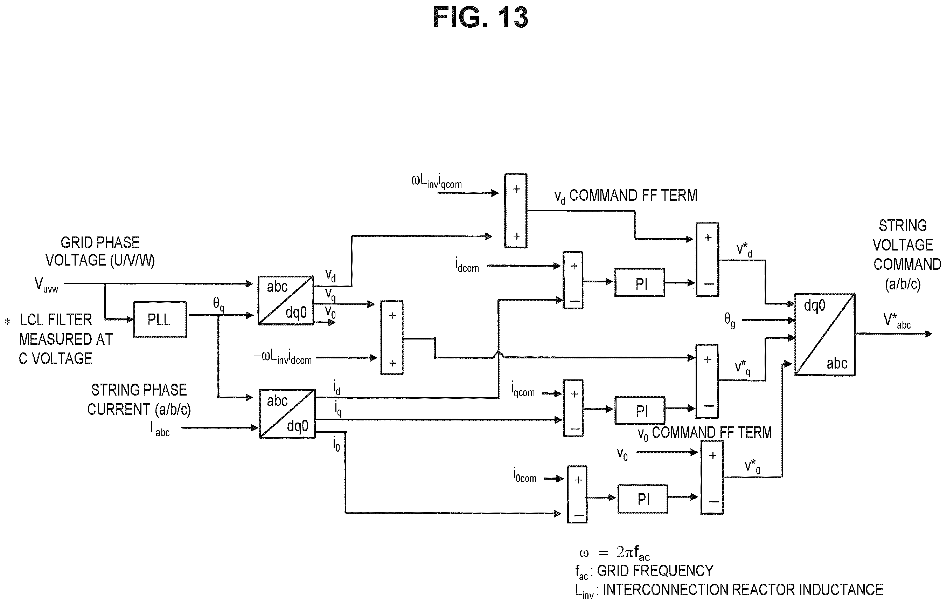

In the three-phase alternating current power supply 200 in the first modified example, as illustrated in FIG. 13, each voltage command value of the d-axis, the q-axis, and the zero-phase can be calculated. The total output from the three phases is denoted by the output power P[kW], and alternating current command values $I_{a\_com\_base}$, $I_{b\_com\_base}$, $I_{c\_com\_base}$ of the strings a, b, c in a case where the same power is output from each phase are represented by the equation (7). The equation (7) indicates a current command value of which phase matches the grid voltage of each phase.

[Equation 7]

$$\begin{pmatrix} I_{a\_com\_base} \\ I_{b\_com\_base} \\ I_{c\_com\_base} \end{pmatrix} = \frac{2P}{3\sqrt{v_d^2 + v_q^2}} \begin{pmatrix} sin\theta_a & 0 & 0 \\ 0 & sin\theta_b & 0 \\ 0 & 0 & sin\theta_c \end{pmatrix} \cdots (7)$$

In a case where each of the strings a, b, c is operated by each of the alternating current command values $I_{a\_com\_base}$, $I_{b\_com\_base}$, $I_{c\_com\_base}$ indicated by the equation (7), output powers Pa, Pb, Pc of each phase are P/3, respectively.

In a case where deterioration states of the batteries 10 constituting each of the strings a, b, c are different, and the power that can be stored in the battery 10 (indicated as string-stored power amounts Qa, Qb, Qc[kWh]) is different, if each of the strings a, b, c outputs the same power Pa, Pb, Pc, the stored power of the string which includes more batteries 10 that are further deteriorated and have a smaller capacity and which has a small stored power amount is exhausted first, thus the battery cannot be discharged and stops operating. When any of the strings a, b, c constituting the three-phase stops operating, the three-phase output may not be achieved.

To avoid such a problem, the equation (8) is used to correct amplitudes of the alternating current command values $I_{a\_com\_base}$, $I_{b\_com\_base}$, $I_{c\_com\_base}$ of the strings a, b, c in the three-phase alternating current power supply 200 of the first modified example. That is, alternating current commands $I_{a\_com}$, $I_{b\_com}$, $I_{c\_com}$ are calculated as corrected by multiplying the alternating current command values $I_{a\_com\_base}$, $I_{b\_com\_base}$, $I_{c\_com\_base}$ of the strings a, b, c, which are calculated using the equation (7), by correction coefficients $k_{pa}$, $k_{pb}$, $k_{pc}$, respectively. The correction terms $k_{pa}$, $k_{pb}$, $k_{pc}$ may be set according to the storage capacity of the batteries 10 constituting each of the strings a, b, c, that is, the stored power amounts Qa, Qb, Qc of the strings a, b, c. For example, it may be set based on the equation (9).

[Equation 8]

$$\begin{pmatrix} I_{a\_com} \\ I_{b\_com} \\ I_{c\_com} \end{pmatrix} = \begin{pmatrix} k_{pa} & 0 & 0 \\ 0 & k_{pb} & 0 \\ 0 & 0 & k_{pc} \end{pmatrix} \begin{pmatrix} I_{a\_com\_base} \\ I_{b\_com\_base} \\ I_{c\_com\_base} \end{pmatrix} \cdots (8)$$

[Equation 9]

$$\begin{pmatrix} k_{pa} \\ k_{pb} \\ k_{pc} \end{pmatrix} = \frac{3}{Q_a + Q_b + Q_c} \begin{pmatrix} Q_a \\ Q_b \\ Q_c \end{pmatrix} \quad \cdots \quad (9)$$

Specifically, a battery level estimation unit is provided to estimate the stored power amounts Qa, Qb, Qc for each battery module 102 of the strings a, b, c, and the stored power amount Qa, Qb, Qc estimated by the battery level estimation unit are used in the control.

As in the equation (2), the alternating current command values $I_{a\_com\_base}$, $I_{b\_com\_base}$, $I_{c\_com\_base}$ of each of the strings a, b, c are subject to the abc / dq0 conversion to calculate the d-axis command current $i_{dcom}$, a q-axis command current $i_{qcom}$, and a zero-phase command current $i_{0com}$. Similar to the first embodiment, a d-axis phase command voltage feedback term $v_{dfb}^*$, a q-axis phase command voltage feedback term $v_{qfb}^*$, and a zero-phase command voltage feedback term $v_{0fb}^*$ are calculated with the PI control, using the d-axis command current $i_{dcom}$, the q-axis command current $i_{qcom}$, and the zero-phase command current $i_{0com}$, as well as a d-axis current $i_d$, a q-axis current $i_q$, and a zero-phase current io. The d-axis phase command voltage feedback term $v_{dfb}^*$, the q-axis phase command voltage feedback term $v_{qfb}^*$, and the zero-phase command voltage feedback term $v_{0fb}^*$ are added to a $v_d$ command feed-forward term, a $v_q$ command feed-forward term, and a $v_0$ command feed-forward term, whereby a d-axis phase voltage command value $v_d^*$, a q-axis phase voltage command value $v_q^*$, and the zero-phase voltage command value $v_0^*$ are calculated. Further, the string voltage command values $V_a^*$, $V_b^*$, $V_c^*$ are calculated by executing the dq0/abc conversion using the equation (5).

Using the string voltage command values $V_a^*$, $V_b^*$, $V_c^*$ (collectively referred to as $V_{abc}^*$), an on-time command value $t_{on\_abc}$ of the strings a, b, c is calculated using the equation (6).

In this way, using the gate driving signals (signal Gate_a, signal Gate_b, signal Gate_c) with the on-period in which only the on-time command value calculated using the equation (6) is present and the off-period thereafter, the switching control of the first switch element 16 and the second switch element 18 is executed in the same manner as in the three-phase alternating current power supply 200 of the first embodiment.

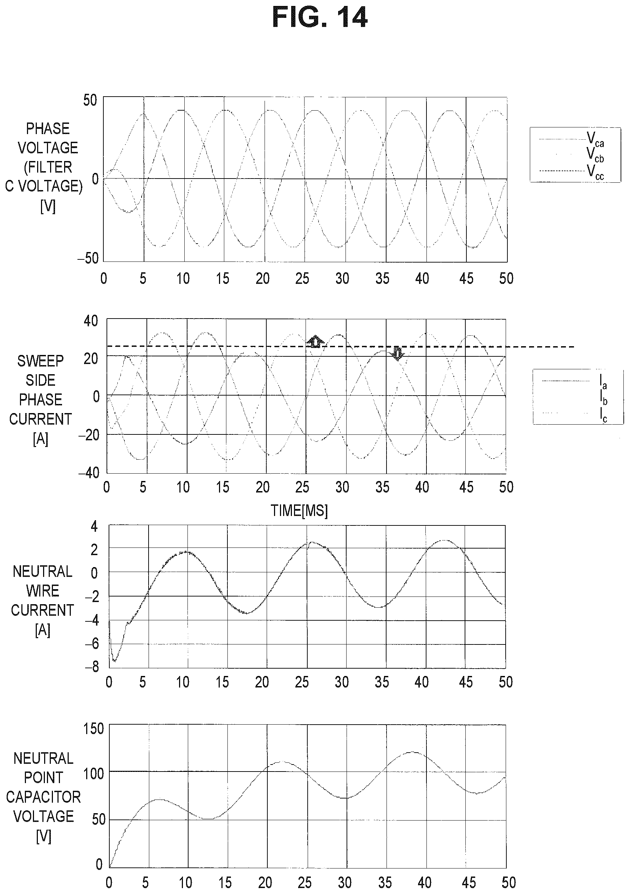

FIG. 14 illustrates an operation waveform in a case where P = 1800[W], $k_{pa}$ = 1.1, $k_{pb}$ = 0.8, $k_{pc}$ = 1.1. This condition corresponds to a case where the string stored power amount Qb of the power supply circuit b is smaller than the string stored power amounts Qa, Qb of the power supply circuits a, c. As illustrated in FIG. 14, the power supply circuit current amplitudes of the a-phase, b-phase, and c-phase could be controlled to 1.1 times, 0.8 times, and 1.1 times, respectively, with respect to the reference value. Further, a current of $i_0 = I_a + I_b + I_c$ flows as a zero-phase current in the neutral wire between the secondary side neutral point of the transformer 204 and the neutral point N of the power supply circuit 100, thereby a phase of the three-phase current matches the phase voltage and can be controlled with the power factor of 1.

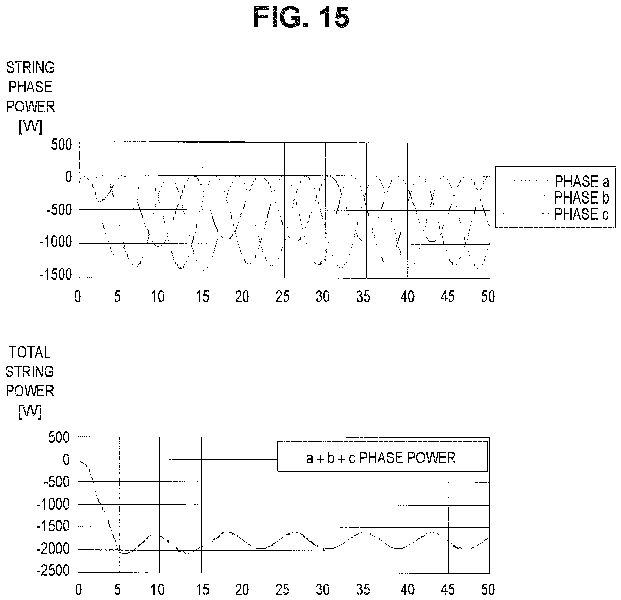

FIG. 15 illustrates the power of the strings a, b, c and the total power. As illustrated in FIG. 15, in the three-phase alternating current power supply 200 of the first modified example, the power of the string b can be controlled to be smaller than that of the strings a, c, and the average power can be controlled to be 1800W.

Second Modified Example

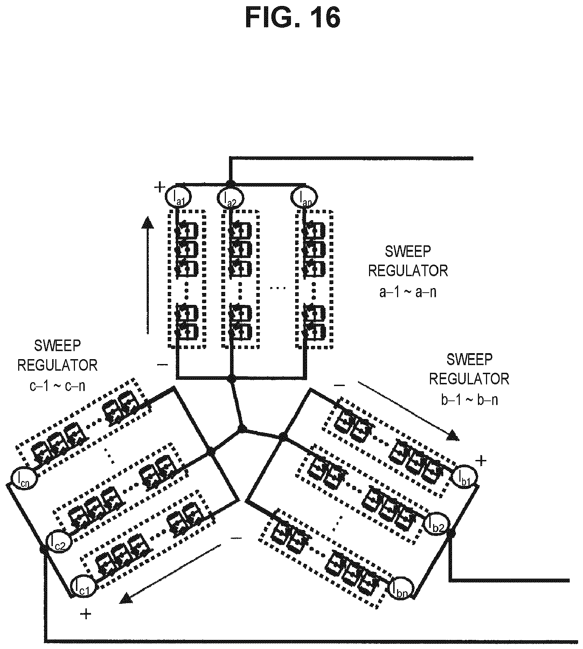

FIG. 16 is a diagram illustrating a configuration of a three-phase alternating current power supply 200 according to a second modified example. In the three-phase alternating current power supply 200 of the second modified example, each of the strings a, b, c has a configuration in which a plurality of power supply circuits 100 is connected in parallel. In the example of FIG. 16, a configuration in which n power supply circuits 100 are connected in parallel to each of the a-phase, b-phase, and c-phase is illustrated.

In this way, by connecting a plurality of power supply circuits 100 in parallel in each phase, the power supply circuit 100 can be disconnected and the output can be maintained even when the power supply circuit 100 fails. Therefore, the operation of the three-phase alternating current power supply 200 can be stabilized.

Second Embodiment (Single-phase Alternating Current Power Supply)

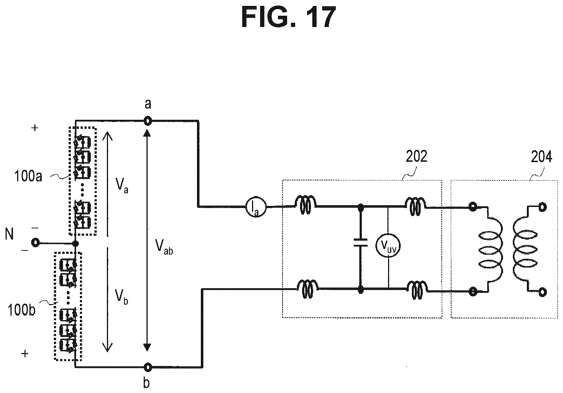

FIG. 17 illustrates a configuration of a single-phase alternating current power supply 300 using the power supply circuit 100. The single-phase alternating current power supply 300 is configured by combining two sets of power supply circuits 100. The negative electrode sides of the two sets of power supply circuits 100 are connected at the neutral point N, and the positive electrode side of each is connected to the transformer 204 via the filter 202.

In the single-phase alternating current power supply 300, one current sensor ($I_a$) and one voltage sensor ($V_{uv}$) are installed. An alternating current command that matches the voltage phase is generated, and Vab is controlled such that the measured current value follows the current command.

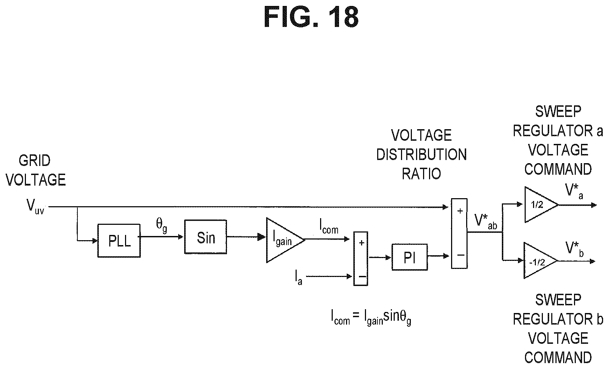

FIG. 18 illustrates a control block of the single-phase alternating current power supply 300. A phase is detected from a grid voltage $V_{uv}$ measured by the voltage sensor using the PLL, and a current command value $I_{com}$ is generated. An output voltage command $V_{ab}^*$ of the single-phase alternating current power supply 300 that reduces a difference between the current command value $I_{com}$ and a current detected value $I_a$ measured by the current sensor is calculated by PI control. The output voltage command $V_{ab}^*$ is multiplied by voltage sharing ratios of the power supply circuits 100 (100a and 100b) at the a-phase and b-phase to calculate voltage command values $V_a^*$ and $V_b^*$ of the a-phase and b-phase, respectively. The on-time command values of the power supply circuits 100 (100a and 100b) at the a-phase and b-phase are calculated based on the voltage command values Va* and $V_b^*$. Since the method of calculating the on-time command value is the same as that of the three-phase alternating current power supply 200 in the first embodiment, the description thereof will be omitted.

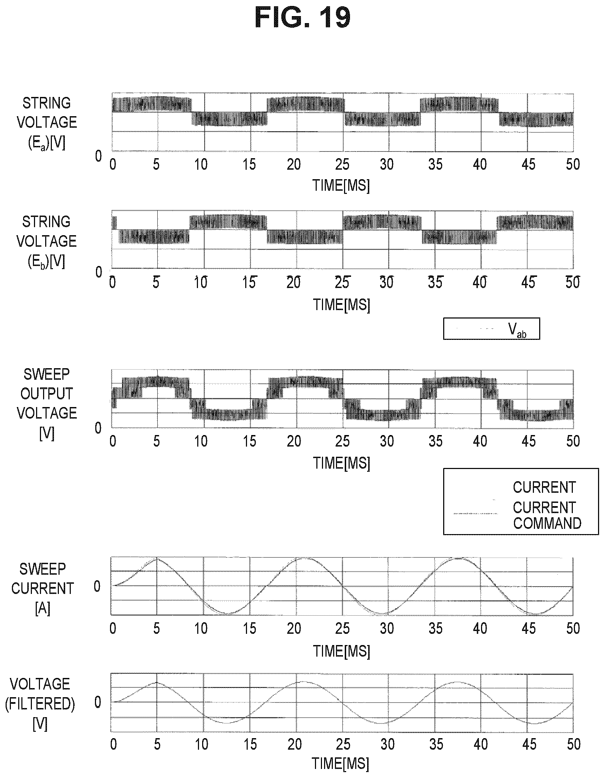

FIG. 19 illustrates an operation waveform of the single-phase alternating current power supply 300. The string voltages of the power supply circuits 100 (100a and 100b) at the a-phase and b-phase are added to obtain a sweep output voltage Vab with an alternating current waveform of the single-phase alternating current power supply 300. As illustrated in FIG. 19, the power factor was approximately 1 due to the relationship between the sweep output voltage Vab and a sweep current lab.

Third Embodiment (Full-bridge)

The power supply circuit 100 described above has a half-bridge configuration, and outputs 0V when the first switch element 16 is turned on and outputs a battery voltage Vb when the second switch element 18 is turned on. Therefore, in a case where the power supply circuit 100 is configured by the battery module 102 having a half-bridge configuration, only a positive voltage of 0 to Vb $\times$ N[V] (N: the number of series-connected batteries 10 included in the battery module 102) can be output.

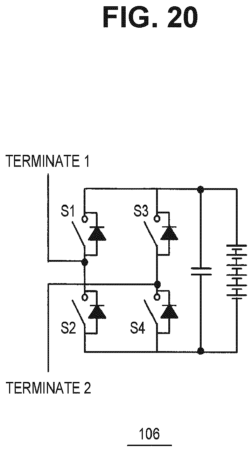

On the other hand, in a case of a battery module 106 having a full-bridge configuration as illustrated in FIG. 20, when a switch element S1 and a switch element S4 are turned on, the voltage Vb is output between terminals 1 and 2, and when the switch element S2 and a switch element S3 are turned on, a voltage (-Vb) is output between the terminals 1 and 2.

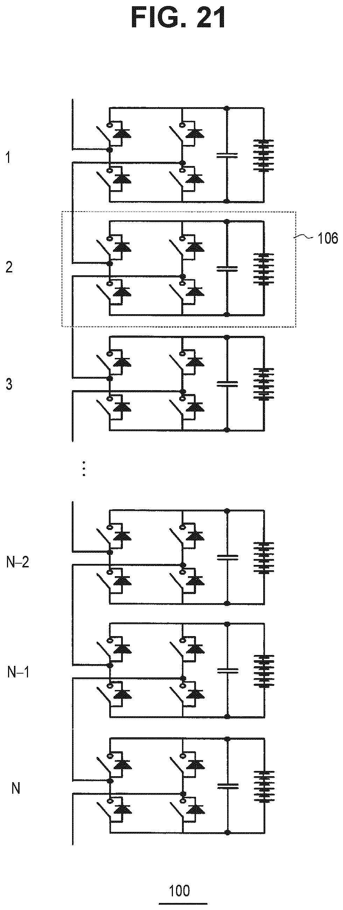

Therefore, as shown in FIG. 21, when N power supply circuits 100 are connected in series in the battery module 106 having a full-bridge configuration, the voltage can be output in a range of (-Vb) $\times$ N to Vb $\times$ N. Therefore, it is not necessary to provide the voltage offset $V_{offset}$ of the string voltage.

Fourth Embodiment (Positive/Negative Reverse Connection)

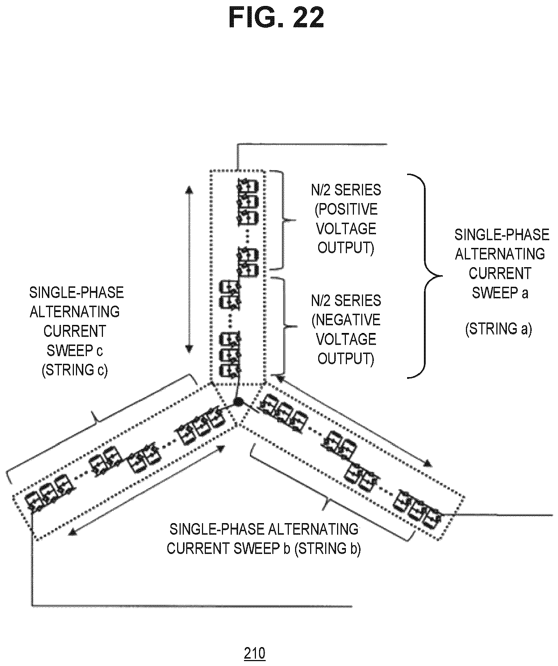

As illustrated in FIG. 22, a three-phase alternating current power supply 210 may be adopted in which N battery modules 102 (or battery modules 106 having a full-bridge configuration) may be divided into two sets of sub-battery modules in the strings a, b, c, respectively, and one sub-battery module and the other sub-battery module are configured to connect the positive electrode sides or the negative electrode sides.

With such a configuration, it is possible to output a voltage in a range of (-$V_b$) $\times$ N/2 to $V_b$ $\times$ N/2 in each of the strings a, b, c. Therefore, it is not necessary to provide an offset ($V_{offset}$) for the string voltage in each of the strings a, b, c.

In each of the strings a, b, c, it is possible to output not only a positive voltage range but also a negative voltage range. Therefore, compared to the three-phase alternating current power supply 200 to which only the positive or negative electrode of the battery module 102 (or the battery module 106 having a full-bridge configuration) is connected as illustrated in FIG. 6, the effective value of the current flowing through each of the batteries 10 can be lowered when the same output is executed, and the loss due to the internal resistance of the battery 10 can be reduced.

The sweep control of each of the strings a, b, c of the three-phase alternating current power supply 210 may be the same as that of the single-phase alternating current power supply 300 illustrated in FIG. 17. When a command voltage for each of the strings a, b, c is positive, the output voltage may be generated by using N/2 power supply circuit modules that output a positive voltage. When a command voltage for each of the strings a, b, c is negative, the output voltage may be generated by using two N/2 power supply circuit modules that output a negative voltage.

In the present embodiment, the battery module 102 is divided into two, but it may be divided into three or more and any of them may be connected in anti-series.

By combining the half-bridge battery modules 102 to form the three-phase alternating current power supply 210, it is possible to output the power in a range of ( -Vb) $\times$ N/2 to Vb $\times$ N/2 and to reduce the number of switch elements, as compared with a case where the battery modules 106 having a full-bridge configuration are used.

Fifth Embodiment (Charge/Discharge System)

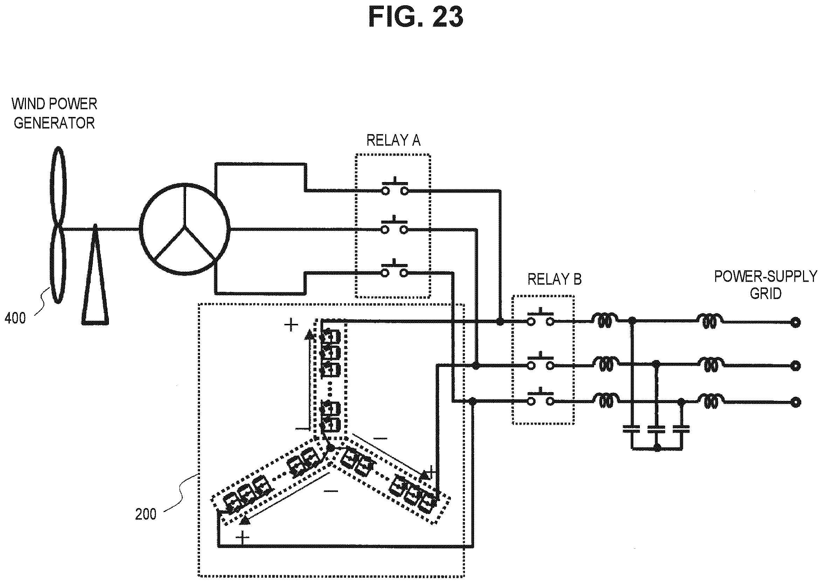

FIG. 23 illustrates a fifth embodiment. The three-phase alternating current power supply 200 is connected to a wind power generator 400 via a relay A, and is connected to a power supply grid via a relay B. In a case where the relay A is connected and the relay B is disconnected, the power generated by the wind power generator 400 is supplied to the three-phase alternating current power supply 200, and the battery 10 included in the three-phase alternating current power supply 200 can be charged. Specifically, the single-phase alternating current power supply 300 can charge the battery 10 with the generated power by controlling a current according to a phase of the voltage generated in the wind power generator 400.

When discharging the power stored in the battery 10 of the three-phase alternating current power supply 200 to the power supply grid, the relay A is disconnected and the relay B is connected. Since a control method for discharging from the three-phase alternating current power supply 200 to the power supply grid is the same as that of the first embodiment, the description thereof will be omitted.

By providing two sets of three-phase alternating current power supplies 200 and alternately connecting to the wind power generator 400 and the power supply grid exclusively, a configuration may be implemented in which the power of the wind power generation is always charged in one of the three-phase alternating current power supplies 200, while the power is discharged from the other three-phase alternating current power supply 200 to the power supply grid.

Instead of the three-phase alternating current power supply 200, the configurations of other embodiments stated above, such as the three-phase alternating current power supply 210 and the single-phase alternating current power supply 300, and other modified examples, may be applied.

## Claims

1.  A power supply system (200) comprising:
    a power supply circuit (100) that includes a plurality of battery modules (102), each of the battery modules having a battery (10), and the power supply circuit (100) being configured to transfer a gate driving signal from a controller (104) between the battery modules (102) such that the batteries (10) in the battery modules (102) are connected to each other in a series connection, wherein
    an alternating current voltage having a different phase is output by temporally changing the number of the batteries (10) connected in series in each of a plurality of power supply circuits (100).

2.  The power supply system (200) according to claim 1, wherein the gate driving signal is given from the controller (104) to each of the power supply circuits (100).

3.  The power supply system (200) according to claim 1 or 2, wherein each of the battery modules (102) includes:

    a first switch element (16) configured to be turned on or off in response to the gate driving signal to disconnect the battery (10) from the series connection;
    a second switch element (18) configured to be turned on or off in response to the gate driving signal to connect the battery (10) in series; and
    a gate driving signal processing circuit (20) configured to delay the gate driving signal at regular time intervals and transmit the gate driving signal to a next-stage battery module (102) connected in series.

4.  The power supply system (200) according to claim 3, wherein:

    each of the battery modules (102) is a half-bridge module including the first switch element (16) and the second switch element (18); and
    an alternating current voltage without an offset voltage is output as a difference between voltages output by the power supply circuits (100), by outputting an alternating current voltage having the same offset voltage in each of the power supply circuits (100).

5.  The power supply system (200) according to claim 3, wherein:

    each of the battery modules (102) is a full-bridge module including the first switch element (16) and the second switch element (18); and
    an alternating current voltage without an offset voltage is output in each of the power supply circuits (100).

6. The power supply system (200) according to any one of claims 1 to 5, wherein the power supply circuit (100) has a configuration in which the battery modules (102) are divided into a plurality of sub-battery module groups where the battery modules (102) are connected in series, and positive electrode sides or negative electrode sides of one of the sub-battery module groups and another of the sub-battery module groups are connected to each other.

7. The power supply system (200) according to any one of claims 1 to 6, wherein the power supply circuits (100) are Y-connected to each other to generate a three-phase alternating current voltage in which voltages have different phases from each other by 120°.

8. The power supply system (200) according to claim 7, further comprising:
a transformer (204) connected to a load side, wherein
a neutral point of the Y-connected power supply circuits (100) and a neutral point of the transformer (204) are connected via a capacitor.

9. The power supply system (200) according to any one of claims 1 to 6, wherein two sets of the power supply circuits (100) are connected to generate a single-phase alternating current voltage in which voltages have different phases from each other by 180°.

10. The power supply system (200) according to any one of claims 1 to 9, further comprising:
a battery level estimation unit configured to estimate a stored power amount of the power supply circuit (100), wherein a power command value used for determining a output power of the power supply circuit (100) is set according to the stored power amount.

11. The power supply system (200) according to any one of claims 1 to 9, further comprising:

current sensors ($I_a$, $I_b$, $I_c$), each of which is directly or indirectly connected to the power supply circuit (100) and configured to detect a phase current in a system of each phase of the alternating current voltage having phases that are different from each other; and
voltage sensors ($V_u$, $V_v$, $V_w$) configured to detect a phase voltage in the system, wherein

the power supply circuit (100) is controlled according to the phase current and the phase voltage.

12. The power supply system (200) according to any one of claims 1 to 11, wherein a plurality of power supply circuits (100) are connected in parallel for each phase of the alternating current voltage having phases that are different from each other.

13. The power supply system (200) according to any one of claims 1 to 12, further comprising:
a forcible disconnection unit (22) configured to forcibly disconnect the battery (10) in the battery module from the series connection regardless of the gate driving signal.

14. The power supply system (200) according to claim 13, further comprising:

a state detection unit configured to detect voltage information or temperature information of the battery (10) included in each of the battery modules (102); and
a battery state estimation unit configured to estimate a state of the battery (10) using the voltage information or the temperature information, wherein

the battery (10) in each of the battery modules (102) is forcibly disconnected from the series connection by the forcible disconnection unit (22) according to the state of the battery (10) estimated by the battery state estimation unit.

15. The power supply system (200) according to any one of claims 1 to 12, further comprising:
a forcible connection unit (24) configured to forcibly connect the battery (10) in each of the battery modules (102) to the series connection regardless of the gate driving signal.

16. The power supply system (200) according to claim 15, further comprising:

a state detection unit configured to detect voltage information or temperature information of the battery (10) included in each of the battery modules (102);

a battery state estimation unit configured to estimate a state of the battery (10) using the voltage information or the temperature information, wherein

the battery (10) in each of the battery modules (102) is forcibly connected to the series connection by the forcible connection unit (24) according to the state of the battery (10) estimated by the battery state estimation unit.

# FIG. 1

# FIG. 2

GATE SIGNAL — OFF / D1 ON / TIME

FIRST SWITCHING ELEMENT S1 — ON / D2 OFF / dt ON / TIME

SECOND SWITCHING ELEMENT S2 — OFF / dt D3 ON / OFF / TIME

BATTERY CIRCUIT MODULE OUTPUT VOLTAGE $V_{mod}$ — 0V( PASS-THROUGH STATE) / D4 $V_{cap}$(CONNECTED STATE) / TIME

# FIG. 3A

# FIG. 3B

# FIG. 4

# FIG. 5

PERIOD A

FORCIBLE DISCONNECTION
COMMAND OF NO. 10 MODULE

PERIOD B

PERIOD C

GATE
CYCLE

tdelay × 14

tdelay × 13

tdelay × 13

tdelay × 14

MODULE NO.

POWER SUPPLY MODULE CONNECTED

START TO FORCIBLY
DISCONNECT
NO. 10 MODULE

FORCIBLE DISCONNECTION OF
NO. 10 MODULE COMPLETED

EP 4 040 631 A1

**FIG. 6**

# FIG. 7

STRING VOLTAGE [V]

$E_a$    $E_c$    $E_b$

$E_{stg}$

$V_{offset}$

TIME[SEC]

# FIG. 8

# FIG. 9

EP 4 040 631 A1

# FIG. 10

STRING VOLTAGE
COMMAND (a/b/c)

$V^*_{abc}$

VOLTAGE COMMAND OFFSET

$V_{st\_offset}$

+
+

×

STRING ON-TIME
COMMAND (a/b/c)

$t_{on\_abc}$

DELAY TIME

$t_{delay}$

×

CARTRIDGE AVERAGE VOLTAGE

$V_{b\_ave}$

÷

# FIG. 11

FIG. 12

# FIG. 13

$\omega L_{inv} i_{qcom}$

$v_d$ COMMAND FF TERM

GRID PHASE
VOLTAGE (U/V/W)

STRING
VOLTAGE
COMMAND
(a/b/c)

$V_{uvw}$

* LCL FILTER
MEASURED AT
C VOLTAGE

$\theta_q$

abc / dq0

$v_d$
$v_q$
$v_0$

$i_{dcom}$

PI

$v^*_d$

$\theta_g$

dq0 / abc

$V^*_{abc}$

$-\omega L_{inv} i_{dcom}$

STRING PHASE
CURRENT (a/b/c)

$I_{abc}$

abc / dq0

$i_d$
$i_q$
$i_0$

$i_{qcom}$

PI

$v^*_q$

$v_0$ COMMAND FF TERM

$v_0$

$i_{0com}$

PI

$v^*_0$

$\omega = 2\pi f_{ac}$
$f_{ac}$ : GRID FREQUENCY
$L_{inv}$ : INTERCONNECTION REACTOR INDUCTANCE

EP 4 040 631 A1

# FIG. 14

# FIG. 15

STRING
PHASE
POWER
[W]

TOTAL
STRING
POWER
[W]

# FIG. 16

# FIG. 17

# FIG. 18

# FIG. 19

STRING
VOLTAGE
(E$_a$)[V]

SWEEP
OUTPUT
VOLTAGE
[V]

STRING
VOLTAGE
(E$_b$)[V]

SWEEP
CURRENT
[A]

VOLTAGE
(FILTERED)
[V]

TIME[MS]

V$_{ab}$

CURRENT
CURRENT
COMMAND

# FIG. 20

TERMINATE 1

S1  S3

S2  S4

TERMINATE 2

106

# FIG. 21

100

# FIG. 22

N/2 SERIES
(POSITIVE
VOLTAGE
OUTPUT)

N/2 SERIES
(NEGATIVE
VOLTAGE
OUTPUT)

SINGLE-PHASE
ALTERNATING
CURRENT
SWEEP a

(STRING a)

SINGLE-PHASE
ALTERNATING
CURRENT
SWEEP c
(STRING c)

SINGLE-PHASE ALTERNATING
CURRENT SWEEP b (STRING b)

210

# FIG. 23

WIND POWER
GENERATOR

RELAY A

RELAY B

POWER-SUPPLY
GRID

400

200

EP 4 040 631 A1

**EP 4 040 631 A1**

Europäisches Patentamt
European Patent Office
Office européen des brevets

# EUROPEAN SEARCH REPORT

Application Number

EP 22 15 5063

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/221878 A1 (FEUERSTACK PETER [DE] ET AL) 29 August 2013 (2013-08-29) * paragraphs [0005] - [0027]; figures 1-3 * ----- | 1-16 | INV. H02J7/00 |
| X | US 2013/285456 A1 (FEUERSTACK PETER [DE] ET AL) 31 October 2013 (2013-10-31) * paragraphs [0025] - [0047]; figures 1,3 * ----- | 1-3,5-16 | |
| A | US 2020/136199 A1 (YANAGIZAWA NAOKI [JP] ET AL) 30 April 2020 (2020-04-30) * abstract; figure 1 * ----- | 1-16 | |

| | TECHNICAL FIELDS SEARCHED (IPC) |
|---|---|
| | H02J |

The present search report has been drawn up for all claims

| Place of search | Date of completion of the search | Examiner |
|---|---|---|
| Munich | 29 June 2022 | Grosse, Philippe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 15 5063

This annex lists the patent family members relating to the patent documents cited in the above-mentioned European search report.
The members are as contained in the European Patent Office EDP file on
The European Patent Office is in no way liable for these particulars which are merely given for the purpose of information.

29-06-2022

| Patent document cited in search report | | | Publication date | Patent family member(s) | | Publication date |
|---|---|---|---|---|---|---|
| US 2013221878 | A1 | | 29-08-2013 | CN | 103098364 A | 08-05-2013 |
| | | | | DE | 102010041059 A1 | 22-03-2012 |
| | | | | EP | 2619894 A2 | 31-07-2013 |
| | | | | US | 2013221878 A1 | 29-08-2013 |
| | | | | WO | 2012038174 A2 | 29-03-2012 |
| US 2013285456 | A1 | | 31-10-2013 | CN | 103262383 A | 21-08-2013 |
| | | | | DE | 102010064311 A1 | 05-07-2012 |
| | | | | EP | 2659566 A2 | 06-11-2013 |
| | | | | KR | 20140007349 A | 17-01-2014 |
| | | | | US | 2013285456 A1 | 31-10-2013 |
| | | | | WO | 2012089395 A2 | 05-07-2012 |
| US 2020136199 | A1 | | 30-04-2020 | CN | 111130342 A | 08-05-2020 |
| | | | | JP | 6960897 B2 | 05-11-2021 |
| | | | | JP | 2020072544 A | 07-05-2020 |
| | | | | US | 2020136199 A1 | 30-04-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018074709 A
- JP 2019216536 A
- JP 2007037290 A
- JP 11089242 A
- JP 2015501127 W
- JP 2018174626 A